(19) Europäisches Patentamt
European Patent Office
Office européen des brevets

(11) EP 3 279 948 A1

(12) EUROPEAN PATENT APPLICATION
published in accordance with Art. 153(4) EPC

(43) Date of publication:
**07.02.2018 Bulletin 2018/06**

(21) Application number: **15887746.4**

(22) Date of filing: **16.11.2015**

(51) Int Cl.:
***H01L 31/049*** *(2014.01)* ***B32B 27/18*** *(2006.01)*
***C08J 7/04*** *(2006.01)* ***C09D 133/04*** *(2006.01)*
***C09D 133/14*** *(2006.01)* ***C09D 183/00*** *(2006.01)*

(86) International application number:
**PCT/JP2015/082160**

(87) International publication number:
**WO 2016/157604 (06.10.2016 Gazette 2016/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **31.03.2015 JP 2015074022**

(71) Applicant: **FUJIFILM Corporation**
**Tokyo 106-8620 (JP)**

(72) Inventors:
- **ISOBE, Yu**
**Fujinomiya-shi**
**Shizuoka 418-8666 (JP)**
- **ITOH, Shigehide**
**Fujinomiya-shi**
**Shizuoka 418-8666 (JP)**

(74) Representative: **Hoffmann Eitle**
**Patent- und Rechtsanwälte PartmbB**
**Arabellastraße 30**
**81925 München (DE)**

# (54) TRANSPARENT SHEET FOR SOLAR CELLS, TRANSPARENT BACK SHEET FOR SOLAR CELLS, AND SOLAR CELL MODULE

(57) Provided are a transparent sheet for a solar cell, a transparent back sheet for a solar cell, and a solar cell module. This transparent sheet for a solar cell includes: a substrate film; and a first polymer layer that is disposed on one surface of the substrate film and includes a polymer A having an ultraviolet absorbing partial structure and a binder polymer B, in which the polymer A having an ultraviolet absorbing partial structure and the binder polymer B have the same kind of structural unit.

EP 3 279 948 A1

**Description**

BACKGROUND OF THE INVENTION

1. Field of the Invention

One embodiment of the present invention relates to a transparent sheet for a solar cell, a transparent back sheet for a solar cell, and a solar cell module.

2. Description of the Related Art

In general, a solar cell module has a structure in which a solar cell is interposed between a front substrate and a back surface protective sheet (hereinafter, also referred to as "back sheet for a solar cell"), the front substrate being disposed on a front surface side where sunlight is incident, the back surface protective sheet being disposed on a side (back surface side) opposite to the front surface side where sunlight is incident, and the solar cells having a structure in which a solar cell element is sealed with a sealing material. In this case, a space between the front substrate and the solar cell and a space between the solar cell and the back sheet for a solar cell are sealed with the sealing material such as an ethylene-vinyl acetate copolymer (EVA), respectively. That is, it is required that the back sheet for a solar cell has adhesiveness with the sealing material.

Further, an environment where a solar cell module is generally used is an outdoor environment where ultraviolet light is directly exposed. Therefore, the light fastness of the back sheet for a solar cell is also important.

Various back sheets for a solar cell having improved light fastness are proposed.

For example, JP2012-69769A discloses a polymer sheet which is used for a back sheet for a solar cell, the polymer sheet including: a polymer support; a first polymer layer that is provided on the polymer support and includes an ultraviolet absorber and a binder polymer; and a second polymer layer that is provided on the first polymer layer and includes a binder polymer and in which the content of an ultraviolet absorber is 1.0 mass% or lower. This polymer sheet can prevent a coating layer, which is formed by coating and is cracked over time, from deterioration such as peeling which may occur over time.

In addition, JP2012-121999A discloses a resin film including: a support; and a polymer layer that is provided at least one surface of the support and includes a triazine compound having a specific structure and a polymer. This resin film has an ultraviolet light shielding effect in a wide wavelength range including a long-wave ultraviolet range of about 400 nm, in which high light fastness is maintained for a long period of time.

In addition, JP2012-256674A discloses a back surface protective sheet for a solar cell module, the back surface protective sheet including: a substrate sheet; and an acrylic polymer-based ultraviolet absorbing layer that is provided on one surface of the substrate sheet, in which the acrylic polymer-based ultraviolet absorbing layer includes a monomer unit having an ultraviolet absorbing unit in a molecule. This back surface protective sheet has excellent ultraviolet absorbing performance, and also has excellent long-term stability such that light deterioration of the substrate sheet is not likely to occur even during long-term use.

SUMMARY OF THE INVENTION

Recently, the use of a solar cell module such as a lighting window for generating power while allowing transmission of light (visible light) has been considered. In a case where a solar cell module is used for such application, it is necessary that the solar cell module has transparency (visible light-transmitting property), and a polymer sheet such as a back sheet for a solar cell, which is used in a solar cell module, is also required to have transparency.

In the related art, a sheet which is colored white or black may be used as a back sheet for a solar cell. In this case, a colorant absorbs ultraviolet light such that deterioration of a substrate film in a back sheet for a solar cell caused by ultraviolet light can be prevented.

On the other hand, in a case where a solar cell module is used in an application where transparency is required, the use of a colorant is not preferable. Therefore, in order to prevent deterioration of a substrate film in a back sheet for a solar cell caused by ultraviolet light, a back sheet in which an ultraviolet absorber is kneaded into a substrate film, or a back sheet in which a layer including an ultraviolet absorber is formed on a substrate film may be used.

In the polymer sheet described in JP2012-69769A, a phenomenon (so-called bleed-out) in which the ultraviolet absorber included in the first polymer layer moves from the inside of the layer to the outside of the layer over time is likely to occur, and the transparency of the polymer sheet tends to deteriorate over time. In addition, in the polymer sheet, the ultraviolet absorber is removed over time, and thus light fastness tends to deteriorate.

The resin film described in JP2012-121999A includes a polymer layer that includes a triazine compound having a specific structure such that excellent light fastness can be maintained for a long period of time. However, it is desired

to further improve bleed-out resistance.

The acrylic polymer-based ultraviolet absorbing layer in the back surface protective sheet described in JP2012-256674A is formed by polymerizing a monomer unit having an ultraviolet absorbing unit with an acrylic polymer, and bleed-out resistance tends to be insufficient.

One embodiment of the present invention has been made in consideration of the above-described circumstances, and an object thereof is to provide a transparent sheet for a solar cell having excellent bleed-out resistance and light fastness, a transparent back sheet for a solar cell, and a solar cell module having long-term durability.

Specific means for achieving the object include the following aspects.

<1> A transparent sheet for a solar cell comprising:

a substrate film; and
a first polymer layer that is disposed on one surface of the substrate film and includes a polymer A having an ultraviolet absorbing partial structure and a binder polymer B, in which the polymer A having an ultraviolet absorbing partial structure and the binder polymer B have the same kind of structural unit.

<2> The transparent sheet for a solar cell according to <1>,
in which the ultraviolet absorbing partial structure of the polymer A having an ultraviolet absorbing partial structure has at least one skeleton selected from the group consisting of a triazine skeleton and a benzotriazole skeleton.
<3> The transparent sheet for a solar cell according to <1> or <2>,
in which the ultraviolet absorbing partial structure of the polymer A having an ultraviolet absorbing partial structure has a triazine skeleton.
<4> The transparent sheet for a solar cell according to any one of <1> to <3>,
in which a ratio of a content of the polymer A having an ultraviolet absorbing partial structure to a content of the binder polymer B is 0.05 to 0.60 by mass.
<5> The transparent sheet for a solar cell according to any one of <1> to <4>,
in which a thickness of the first polymer layer is 1 $\mu$m to 15 $\mu$m.
<6> The transparent sheet for a solar cell according to any one of <1> to <5>, further comprising:

a second polymer layer that is provided on the first polymer layer and includes a filler.

<7> The transparent sheet for a solar cell according to any one of <1> to <6>,
in which a ratio of a content of the polymer A having an ultraviolet absorbing partial structure to a content of the binder polymer B is 0.10 to 0.40 by mass.
<8> The transparent sheet for a solar cell according to any one of <1> to <7>, further comprising:

a third polymer layer that is provided on a surface of the substrate film opposite to the surface, where the first polymer layer is disposed, and includes the polymer A having an ultraviolet absorbing partial structure and a binder polymer C.

<9> The transparent sheet for a solar cell according to any one of <1> to <8>,
in which at least one polymer layer including the polymer A having an ultraviolet absorbing partial structure includes an ultraviolet absorbing acrylic resin as the polymer A having an ultraviolet absorbing partial structure and includes an acrylic resin as the binder polymer.
<10> The transparent sheet for a solar cell according to any one of <1> to <9>,
in which the binder polymer B is a siloxane-containing acrylic resin.
<11> The transparent sheet for a solar cell according to any one of <1> to <10>,
in which the first polymer layer further includes an oxazoline crosslinking agent.
<12> The transparent sheet for a solar cell according to <11>,
in which the first polymer layer further includes a crosslinking catalyst.
<13> The transparent sheet for a solar cell according to any one of <1> to <12>,
in which the substrate film is a polyester film.
<14> A transparent back sheet for a solar cell comprising:

the transparent sheet for a solar cell according to any one of <1> to <13>.

<15> A solar cell module comprising:

an element structure portion that includes a solar cell element and a sealing material for sealing the solar cell element;
a transparent substrate that is disposed on one surface of the element structure portion and on which sunlight is incident; and
the transparent back sheet for a solar cell according to [14] that is disposed on the other surface of the element structure portion.

According to one embodiment of the present invention, a transparent sheet for a solar cell having excellent bleed-out resistance and light fastness, a transparent back sheet for a solar cell, and a solar cell module having long-term durability can be provided.

DESCRIPTION OF THE PREFERRED EMBODIMENTS

<Transparent Sheet for Solar Cell>

A transparent sheet for a solar cell includes: a substrate film; and a first polymer layer that includes a polymer A having an ultraviolet absorbing partial structure and a binder polymer B, in which the polymer A having an ultraviolet absorbing partial structure and the binder polymer B have the same kind of structural units.
It is preferable that the transparent sheet for a solar cell further includes a second polymer layer as a scratch-resistant layer that is provided on the first polymer layer.
The transparent sheet for a solar cell may include layers in addition to the first polymer layer and the second polymer layer.
"The transparent sheet" refers to a back sheet having a total light transmittance of 80% or higher.
The action and effect of one embodiment of the present invention is not clear but is presumed to be as follows.
In the related art, in order to prevent deterioration of a substrate film in a back sheet for a solar cell caused by ultraviolet light, an ultraviolet absorber is kneaded into a substrate film, or a layer including an ultraviolet absorber is formed on a substrate film. However, the ultraviolet absorber having a low molecular weight tends to move to the outside of the layer, and deterioration in the light fastness and transparency of the back sheet for a solar cell is of concern.
On the other hand, in the transparent sheet for a solar cell according to the embodiment of the present invention, the first polymer layer includes the polymer A having an ultraviolet absorbing partial structure. Therefore, it is considered that bleed-out is not likely to occur and light fastness is excellent, as compared to the back sheet for a solar cell of the related art which includes the ultraviolet absorber having a low molecular weight. Further, the first polymer layer includes the binder polymer B having the same kind of structural unit as that of the polymer A having an ultraviolet absorbing partial structure. Therefore, compatibility between the two polymers is excellent, and the bleed-out of the polymer A having an ultraviolet absorbing partial structure is prevented.
It is considered that, in the transparent sheet for a solar cell, bleed-out resistance and light fastness are excellent due to the above-described effects.
Further, it is considered that, in a case where the polymer A having an ultraviolet absorbing partial structure having high ultraviolet absorbing performance is selected and used, even when the content of the polymer A having an ultraviolet absorbing partial structure in the first polymer layer is low, the first polymer layer can exhibit excellent light fastness. Likewise, it is considered that, even when the thickness of the first polymer layer is small, the first polymer layer can exhibit excellent light fastness.
Hereinafter, each layer of the transparent sheet for a solar cell will be described.

[First Polymer Layer]

The transparent sheet for a solar cell includes: a substrate film; and a first polymer layer that is disposed on one surface of the substrate film and includes a polymer A having an ultraviolet absorbing partial structure (hereinafter, simply referred to as "polymer A") and a binder polymer B (hereinafter, simply referred to as "polymer B"), in which the polymer A having an ultraviolet absorbing partial structure and the binder polymer B have the same kind of structural units.
"The polymer A having an ultraviolet absorbing partial structure and the binder polymer B have the same kind of structural units" represents that the molecules of the two polymers have the same or similar structural units. Specifically, for example, in a case where the polymer A has a structural unit derived from acrylic acid, the polymer B may have a structural unit derived from acrylic acid which is the same as that of the polymer A, or a structural unit derived from methacrylic acid which is similar to that of the polymer A. Likewise, for example, in a case where the polymer A has a structural unit derived from methacrylic acid, the polymer B may have a structural unit derived from methacrylic acid which is the same as that of the polymer A, or a structural unit derived from acrylic acid which is similar to that of the polymer A.

In addition, in a case where the polymer A has a structural unit derived from acrylic acid and a structural unit derived from a urethane bond, the polymer B may have a structural unit which is the same as or similar to the structural unit derived from acrylic acid, or may have a structural unit which is the same as or similar to the structural unit derived from a urethane bond.

As described above, "the same kind of structural units" are not necessarily exactly the same and are not particularly limited as long as compatibility between the polymers is high.

In addition, it is preferable that the structures of the polymer A having an ultraviolet absorbing partial structure and the binder polymer B have 50 mass% or higher of the same kind of structural units, respectively.

Since the compatibility between the two polymers is excellent, the polymer A having an ultraviolet absorbing partial structure can remain in the layer. That is, bleed-out in which the polymer A having an ultraviolet absorbing partial structure moves from the inside of the layer to the outside of the layer can be prevented.

Since the transparent sheet for a solar cell includes the first polymer layer having the above-described configuration, the substrate film of the transparent sheet for a solar cell is protected from ultraviolet light, and deterioration of the substrate film is prevented. Further, since the first polymer layer includes the polymer A having an ultraviolet absorbing partial structure and the binder polymer B, bleed-out resistance is excellent. As a result, the transparent sheet for a solar cell has excellent light fastness and bleed-out resistance for a long period of time.

(Polymer A having Ultraviolet Absorbing Partial Structure)

The first polymer layer includes at least one kind of the polymer A having an ultraviolet absorbing partial structure.

Since the first polymer layer includes the polymer A having an ultraviolet absorbing partial structure, the first polymer layer functions as an ultraviolet absorbing layer. Since the polymer A having an ultraviolet absorbing partial structure and the binder polymer B described below have the same kind of structural units, the two polymers are likely to have high compatibility, and bleed-out is prevented.

It is preferable that an effective absorption wavelength of the ultraviolet absorbing partial structure is 250 nm to 380 nm.

The polymer A having an ultraviolet absorbing partial structure may have a configuration in which the ultraviolet absorbing partial structure is directly bonded to a main chain or a side chain of the polymer, or a configuration in which the ultraviolet absorbing partial structure is included in the polymer without being directly bonded to the polymer.

Examples of a skeleton having ultraviolet absorbing performance included in the ultraviolet absorbing partial structure include a triazine skeleton, a benzotriazole skeleton, a benzophenone skeleton, and a salicylic acid skeleton. Among these, from the viewpoint of ultraviolet absorbing performance, a triazine skeleton or a benzotriazole skeleton is preferable, and a triazine skeleton is more preferable.

As the skeleton having ultraviolet absorbing performance included in the ultraviolet absorbing partial structure, one kind may be included alone, or two or more kinds may be included.

As a partial structure having a triazine skeleton, a structure having an effective absorption wavelength of about 270 nm to 380 nm is preferable. Specific Examples of the partial structure having a triazine skeleton include a structure derived from a triazine compound which is an ultraviolet absorbing compound shown below. The ultraviolet absorbing compound refers to an ultraviolet absorber having a low molecular weight, not a polymerized ultraviolet absorber.

Examples of the triazine compound include 2-(4-butoxy-2-hydroxyphenyl)-4,6-bis(4-butoxyphenyl)-1,3,5-triazine, 2-(4-butoxy-2-hydroxyphenyl)-4,6-bis(2,4-dibutoxyphenyl)-1,3,5-triazine, 2,4-bis(4-butoxy-2-hydroxyphenyl)-6-(4-butoxyphenyl)-1,3,5-triazine, 2,4-bis(4-butoxy-2-hydroxyphenyl)-6-(2,4-dibutoxyphenyl)-1,3,5-triazine, 2,4,6-tris(2-hydroxy-4-octyloxyphenyl)-1,3,5-triazine, 2-(2-hydroxy-4-octyloxyphenyl)-4,6-bis(2,4-dimethylphenyl)-1,3,5-triazine, 2-(2,4-dihydroxyphenyl)-4,6-bis(2,4-dimethylphenyl)-1,3,5-triazine, 2,4-bis(2-hydroxy-4-propyloxyphenyl)-6-(2,4-dimethylphenyl)-1,3,5-triazine, 2-(2-hydroxy-4-octyloxyphenyl)-4,6-bis(4-methylphenyl)-1,3,5-triazine, 2-(2-hydroxy-4-dodecyloxyphenyl)-4,6-bis(2,4-dimethylphenyl)-1,3,5-triazine, 2-(2-hydroxy-4-tridecyloxyphenyl)-4,6-bis(2,4-dimethylphenyl)-1,3,5-triazine, 2-[2-hydroxy-4-(2-hydroxy-3-butyloxypropoxy)phenyl]-4,6-bis(2,4-dimethyl)-1,3,5-triazine, 2-[2-hydroxy-4-(2-hydroxy-3-octyloxypropyloxy)phenyl]-4,6-bis(2,4-dimethyl)-1,3,5-triazine, 2-[4-(dodecyloxy/tridecyloxy-2-hydroxypropoxy)-2-hydroxyphenyl]-4,6-bis(2,4-dimethylphe nyl)-1,3,5-triazine, 2-[2-hydroxy-4-(2-hydroxy-3-dodecyloxypropoxy)phenyl]-4,6-bis(2,4-dimethylphenyl)-1,3,5-triazine, 2-(2-hydroxy-4-hexyloxy)phenyl-4,6-diphenyl-1,3,5-triazine, 2-(2-hydroxy-4-methoxyphenyl)-4,6-diphenyl-1,3,5-triazine, 2,4,6-tris(2-hydroxy-4-(3-butoxy-2-hydroxypropoxy)phenyl]-1,3,5-triazine, 2-(2-hydroxyphenyl)-4-(4-methoxyphenyl)-6-phenyl-1,3,5-triazine, 2-{2-hydroxy-4-[3-(2-ethylhexyl-1-oxy)-2-hydroxy-propyloxy]phenyl}-4,6-bis(2,4-dimethylp henyl)-1,3,5-triazine, and 2-(2-hydroxy-4-(2-ethylhexyl)oxy)phenyl-4,6-bis(4-phenyl)phenyl-1,3,5-triazine.

As a partial structure having a benzotriazole skeleton, a structure having an effective absorption wavelength of about 270 nm to 380 nm is preferable. Specific Examples of the partial structure having a benzotriazole skeleton include a structure derived from a benzotriazole compound which is an ultraviolet absorbing compound shown below.

Examples of the benzotriazole compound include 2-(2'-hydroxy-5'-methylphenyl)benzotriazole, 2-(2'-hydroxy-5'-t-butylphenyl)benzotriazole, 2-(2'-hydroxy-3'-t-butyl-5'-methylphenyl)-5-chlorobenzotriazole, 2-(2'-hydroxy-3',5'-di-t-butylphenyl)-5-chlorobenzotriazole, 2-(2'-hydroxy-3'-dodecyl-5'-methylphenyl)-5-chlorobenzotriazole, 2-(2'-hydroxy-3',5'-di-t-amylphenyl)benzotriazole, 2-(2'-hydroxy-5'-(1,1,3,3-tetramethylbutyl)phenyl)benzotriazole, 2-(2'-hydroxy-4'-octyloxyphenyl)benzotriazole, 2-(2'-hydroxy-3'-(3,4,5,6-tetrahydrophthalimidylmethyl)-5'-methylbenzyl)phenyl)benzotriazo le, 2-(3'-sec-butyl-5'-t-butyl-2'-hydroxyphenyl)benzotriazole, 2-(3',5'-bis-(α,α-dimethylbenzyl)-2'-hydroxyphenyl)benzotriazole, 2-(3'-t-butyl-2'-hydroxy-5'-(2-octyloxycarbonylethyl)phenyl)-5-chloro-benzotriazole, 2-(3'-t-butyl-5'-[2-(2-ethylhexyloxy)-carbonylethyl]-2'-hydroxyphenyl)-5-chloro-benzotriazol e, 2-(3'-t-butyl-2'-hydroxy-5'-(2-methoxycarbonylethyl)phenyl)-5-chloro-benzotriazole, 2-(3'-t-butyl-2'-hydroxy-5'-(2-methoxycarbonylethyl)phenyl)-benzotriazole, 2-(3'-t-butyl-2'-hydroxy-5'-(2-octyloxycarbonylethyl)phenyl)-benzotriazole, 2-(3'-t-butyl-5'-[2-(2-ethylhexyloxy)carbonylethyl]-2'-hydroxyphenyl)benzotriazole, 2-(3'-dodecyl-2'-hydroxy-5'-methylphenyl)benzotriazole, 2-(3'-t-butyl-2'-hydroxy-5'-(2-isooctyloxycarbonylethyl)phenylbenzotriazole, and 2,2'-methylene-bis[4-(1,1,3,3-tetramethylbutyl)-6-benzotriazole-2-ylphenol].

As a partial structure having a benzophenone skeleton, a structure having an effective absorption wavelength of about 270 nm to 380 nm is preferable. Specific Examples of the partial structure having a benzophenone skeleton include a structure derived from a benzophenone compound which is an ultraviolet absorbing compound shown below.

Examples of the benzophenone compound include 2,4-dihyroxybenzophenone, 2-hydroxy-4-methoxybenzophenone, 2-hydroxy-4-octyloxybenzophenone, 2-hydroxy-4-decyloxybenzophenone, 2-hydroxy-4-dodecyloxybenzophenone, 2-hydroxy-4-benzyloxybenzophenone, 2-hydroxy-4-(2-hydroxy-3-methacryloxypropoxy)benzophenone, 2-hydroxy-4-methoxy-5-sulfobenzophenone, 2-hydroxy-4-methoxy-5-sulfobenzophenonetrihydrate, 2-hydroxy-4-methoxy-2'-carboxybenzophenone, 2-hydroxy-4-octadecyloxybenzophenone, 2-hydroxy-4-diethylamino-2'-hexyloxycarbonylbenzophenone, 2,2' -dihydroxy-4-methoxybenzophenone, 2,2' ,4,4' -tetrahydroxybenzophenone, 2,2' -dihydroxy-4,4' -dimethoxybenzophenone, and 1,4-bis(4-benzyloxy-3-hydroxyphenoxy)butane.

As a partial structure having a salicylic acid skeleton, a structure having an effective absorption wavelength of about 290 nm to 330 nm is preferable. Specific Examples of the partial structure having a salicylic acid skeleton include a structure derived from a salicylic acid compound which is an ultraviolet absorbing compound shown below.

Examples of the salicylic acid compound include phenyl salicylate, 4-t-butylphenyl salicylate, 4-octylphenyl salicylate, dibenzoylresorcinol, bis(4-t-butylbenzoyl)resorcinol, benzoylresorcinol, 2,4-di-t-butylphenyl-3,5-di-t-butyl-4-hydroxysalicylate, and hexadecyl-3,5-di-t-butyl-4-hydroxysalicylate.

As a partial structure having an oxalic diamide skeleton, a structure having an effective absorption wavelength of about 250 nm to 350 nm is preferable. Specific Examples of the partial structure having an oxalic diamide skeleton include a structure derived from an oxalic diamide compound which is an ultraviolet absorbing compound shown below.

Examples of the oxalic diamide compound include 4,4' -dioctyloxyoxanilide, 2,2' -dioctyloxy-5,5' -di-t-butyloxanilide, 2,2' -didodecyloxy-5,5' -t-butyloxanilide, 2-ethoxy-2' -ethyloxanilide, N,N' -bis(3-dimethylaminopropyl)oxamide, 2-ethoxy-5-t-butyl-2' -ethyloxanilide, and 2-ethoxy-2' -ethyl-5,4' -di-t-butyloxanilide.

As long as the polymer A having an ultraviolet absorbing partial structure has the same kind of structural unit as that of the binder polymer B described below, the kind of the polymer A is not particularly limited.

Examples of a polymer, which can form a structural unit other than the ultraviolet absorbing partial structure in the polymer A having an ultraviolet absorbing partial structure, include an acrylic resin, a polyester resin, a polyurethane resin, a polyolefin resin, a silicone resin, and a fluororesin.

"Acrylic resin" refers to a resin having a structural unit derived from acrylic acid or methacrylic acid. Examples of the acrylic resin include a homopolymer of acrylic acid, a homopolymer of methacrylic acid, a homopolymer of acrylic acid ester, a homopolymer of methacrylic acid ester, a copolymer of acrylic acid and another monomer, a copolymer of methacrylic acid and another monomer, a copolymer of acrylic acid ester and another monomer, and a copolymer of methacrylic acid and another monomer.

The acrylic resin is not particularly limited as long as it is a resin having a structural unit derived from acrylic acid or methacrylic acid.

It is preferable that the acrylic resin is a homopolymer or a copolymer of the following monomers.

Examples of the monomer which forms the acrylic resin include acrylic acid, methacrylic acid, and a (meth)acrylic acid ester such as methyl (meth)acrylate, ethyl (meth)acrylate, n-propyl (meth)acrylate, isopropyl (meth)acrylate, n-butyl (meth)acrylate, isobutyl (meth)acrylate, tert-butyl (meth)acrylate, n-hexyl (meth)acrylate, 2-ethylhexyl (meth)acrylate, acetoxyethyl (meth)acrylate, phenyl (meth)acrylate, 2-methoxyethyl (meth)acrylate, 2-ethoxyethyl (meth)acrylate, 2-(2-methoxyethoxy)ethyl (meth)acrylate, cyclohexyl (meth)acrylate, benzyl (meth)acrylate, diethylene glycol monomethyl ether (meth)acrylate, diethylene glycol monoethyl ether (meth)acrylate, diethylene glycol monophenyl ether (meth)acrylate, triethylene glycol monomethyl ether (meth)acrylate, triethylene glycol monoethyl ether (meth)acrylate, dipropylene glycol monomethyl ether (meth)acrylate, polyethylene glycol monomethyl ether (meth)acrylate, polypropylene glycol monomethyl ether (meth)acrylate, monomethyl ether (meth)acrylate of a copolymer of ethylene glycol and propylene glycol, N,N-dimethylaminoethyl (meth)acrylate, N,N-diethylaminoethyl (meth)acrylate, or N,N-dimethylaminopropyl (meth)acrylate.

(Meth)acrylate represents at least one of methacrylate or acrylate. In addition, (meth)acryl represents at least one of methacryl or acryl.

In a case where the acrylic resin is a copolymer of two or more monomers, a monomer (another monomer) other than the above-described monomers may be a copolymerization component.

Examples of the other monomer include a nitrogen-containing monomer such as (meth)acrylamide, diacetone acrylamide, N-methylolacrylamide, or (meth)acrylonitrile; a monomer having a styrene skeleton such as styrene, α-methylstyrene, divinylbenzene, or vinyl toluene; a monomer having a siloxane structure described below; a vinyl ester such as vinyl propionate, a phosphorus-containing vinyl monomer; a vinyl halide such as vinyl chloride or vinylidene chloride; and a conjugated diene such as butadiene.

Examples of the polyester resin include polyethylene terephthalate (PET) and polyethylene-2,6-naphthalate (PEN).

Examples of the polyurethane resin include a carbonate-based urethane resin.

Examples of the polyolefin resin include a modified polyolefin copolymer.

The silicone resin is a polymer having a (poly)siloxane structure in a molecular chain, and the details of the silicone resin will be described below in "(Binder Polymer B)".

The fluororesin is not particularly limited as long as it is a polymer having a structural unit represented by $-(CFX^1-CX^2X^3)-$ (wherein $X^1$, $X^2$, and $X^3$, each independently represent a hydrogen atom, fluorine atom, a chlorine atom, or a perfluoroalkyl group having 1 to 3 carbon atoms). The details of the fluororesin will be described below in "(Binder Polymer B)".

In particular, from the viewpoint of light fastness, it is preferable that the polymer A having an ultraviolet absorbing partial structure is an acrylic resin having an ultraviolet absorbing partial structure (hereinafter, also referred to as "ultraviolet absorbing acrylic resin").

The polymer A having an ultraviolet absorbing partial structure can be obtained by introducing an ultraviolet absorbing partial structure into a polymer which can form a structural unit. A method of introducing an ultraviolet absorbing partial structure into a polymer which can form a structural unit is not particularly limited, and a well-known method can be used.

Specifically, for example, in a case where the polymer A having an ultraviolet absorbing partial structure is obtained by introducing an ultraviolet absorbing partial structure into an acrylic resin, the polymer A having an ultraviolet absorbing partial structure can be obtained by polymerizing an ultraviolet absorbing compound, a monomer (for example, methyl methacrylate) for forming an acrylic resin, and optionally another monomer.

In addition, the polymer A having an ultraviolet absorbing partial structure can be obtained by polymerizing a monomer for forming an acrylic resin and optionally another monomer to form a polymer and then substituting a part of the polymer with an ultraviolet absorbing partial structure.

Further, the polymer A having an ultraviolet absorbing partial structure can be obtained by emulsifying and polymerizing an acrylic resin and an ultraviolet absorbing compound such that the polymer matrix includes the ultraviolet absorbing compound.

As the polymer A having an ultraviolet absorbing partial structure, a commercially available product may be used. Examples of the commercially available product include: TINUVIN (registered trade name) 99-DW, 400-DW, 477-DW, and 479-DW (all of which are manufactured by BASF SE); NEWCOAT (registered trade name) UVA-204W, UVA-101, UVA-102, UVA-103, and UVA-104, VANARESIN (registered trade name) UVA-5080, UVA-5080 (OHV20), UVA-55T, UVA-55MHB, UVA-7075, UVA-7075 (OHV20), and UVA-73T (all of which are manufactured by Shin-Nakamura Chemical Co., Ltd.); and RUVA-93 (manufactured by Otsuka Chemical Co., Ltd.).

From the viewpoints of light fastness and bleed-out resistance, the content of the ultraviolet absorbing partial structure in the polymer A having an ultraviolet absorbing partial structure is preferably 1 mol% to 80 mol%, more preferably 5 mol% to 70 mol%, and still more preferably 10 mol% to 60 mol% with respect to the structural unit.

From the viewpoint of light fastness, the weight-average molecular weight of the polymer A having an ultraviolet absorbing partial structure is preferably 5,000 to 200,000, more preferably 7,000 to 150,000, and still more preferably 10,000 to 100,000.

The weight-average molecular weight can be measured by gel permeation chromatography (GPC). In the GPC measurement, HLC (registered trade name)-8020GPC (manufactured by Tosoh Corporation) is used as a measuring device, three pieces of TSKgel (registered trade name) Super Multipore HZ-H (4.6 mm ID $\times$15 cm, manufactured by Tosoh Corporation) are used as columns, and tetrahydrofuran (THF) is used as an eluent. In addition, the measurement can be used using a differential refractive index (RI) detector under measurement conditions of sample concentration: 0.45 mass%, flow rate: 0.35 ml/min, sample injection volume: 10 $\mu$l, and measurement temperature: 40°C.

A calibration curve can be obtained from 8 samples of "Standard sample, TSK standard, polystyrene": "F-40", "F-20", "F-4", "F-1", "A-5000", "A-2500", "A-1000", and "n-propylbenzene" (manufactured by Tosoh Corporation).

The content of the polymer A having an ultraviolet absorbing partial structure in the first polymer layer is preferably 1 mass% to 50 mass%, more preferably 5 mass% to 35 mass%, and still more preferably 10 mass% to 25

mass% with respect to the solid content of the first polymer layer.

It is preferable that a ratio of the content of the polymer A having an ultraviolet absorbing partial structure to the content of the binder polymer B in the first polymer layer is 0.05 to 0.60 by mass. In a case where the ratio of the content of the polymer A having an ultraviolet absorbing partial structure to the content of the binder polymer B is 0.05 or higher, light fastness is further improved. In addition, in a case where the content ratio is 0.60 or lower, bleed-out resistance is further improved.

From the same viewpoints, it is more preferable that a ratio of the content of the polymer A having an ultraviolet absorbing partial structure to the content of the binder polymer B is 0.10 to 0.40 by mass.

(Binder Polymer B)

The first polymer layer includes at least one kind of the binder polymer B.

Since the first polymer layer includes the binder polymer B, the polymer A having an ultraviolet absorbing partial structure included in the first polymer layer is held, and the first polymer layer functions as an ultraviolet absorbing layer. Since the binder polymer B and the polymer A having an ultraviolet absorbing partial structure have the same kind of structural units, the two polymers are likely to have high compatibility, and bleed-out is prevented.

The binder polymer B is not particularly limited as long as it has the same kind of structural unit as that of the polymer A having an ultraviolet absorbing partial structure.

Examples of the binder polymer B include an acrylic resin, a polyester resin, a polyurethane resin, a polyolefin resin, a silicone resin, and a fluororesin. In addition, the binder polymer B may be a composite resin, for example, a siloxane-containing acrylic resin as a composite resin of an acrylic resin and a silicone resin.

~Acrylic Resin~

The acrylic resin is not particularly limited as long as it is a resin having a structural unit derived from acrylic acid or methacrylic acid.

It is preferable that the acrylic resin is a homopolymer or a copolymer of the following monomers.

Examples of the monomer which forms the acrylic resin include acrylic acid, methacrylic acid, and a (meth)acrylic acid ester such as methyl (meth)acrylate, ethyl (meth)acrylate, n-propyl (meth)acrylate, isopropyl (meth)acrylate, n-butyl (meth)acrylate, isobutyl (meth)acrylate, tert-butyl (meth)acrylate, n-hexyl (meth)acrylate, 2-ethylhexyl (meth)acrylate, acetoxyethyl (meth)acrylate, phenyl (meth)acrylate, 2-methoxyethyl (meth)acrylate, 2-ethoxyethyl (meth)acrylate, 2-(2-methoxyethoxy)ethyl (meth)acrylate, cyclohexyl (meth)acrylate, benzyl (meth)acrylate, diethylene glycol monomethyl ether (meth)acrylate, diethylene glycol monoethyl ether (meth)acrylate, diethylene glycol monophenyl ether (meth)acrylate, triethylene glycol monomethyl ether (meth)acrylate, triethylene glycol monoethyl ether (meth)acrylate, dipropylene glycol monomethyl ether (meth)acrylate, polyethylene glycol monomethyl ether (meth)acrylate, polypropylene glycol monomethyl ether (meth)acrylate, monomethyl ether (meth)acrylate of a copolymer of ethylene glycol and propylene glycol, N,N-dimethylaminoethyl (meth)acrylate, N,N-diethylaminoethyl (meth)acrylate, or N,N-dimethylaminopropyl (meth)acrylate.

(Meth)acrylate represents at least one of methacrylate or acrylate. In addition, (meth)acryl represents at least one of methacryl or acryl.

In a case where the acrylic resin is a copolymer of two or more monomers, a monomer (another monomer) other than the above-described monomers may be a copolymerization component.

Examples of the other monomer include a nitrogen-containing monomer such as (meth)acrylamide, diacetone acrylamide, N-methylolacrylamide, or (meth)acrylonitrile; a monomer having a styrene skeleton such as styrene, α-methylstyrene, divinylbenzene, or vinyl toluene; a monomer having a siloxane structure described below; a vinyl ester such as vinyl propionate, a phosphorus-containing vinyl monomer; a vinyl halide such as vinyl chloride or vinylidene chloride; and a conjugated diene such as butadiene.

As the acrylic resin used as the binder polymer B, a copolymer of the above-described monomer for forming an acrylic resin and a monomer having a styrene skeleton (an acrylic resin having a styrene skeleton) or a copolymer of the above-described monomer for forming an acrylic resin and a monomer having a (poly)siloxane structure described below (siloxane-containing acrylic resin) is preferable, and from the viewpoints of the strength of the first polymer layer and durability in a hot humid environment, a copolymer of the above-described monomer for forming an acrylic resin and a monomer having a siloxane structure described below is more preferable.

As the monomer having a (poly)siloxane structure, a monomer having a siloxane structural unit represented by the following Formula (1) is preferable.

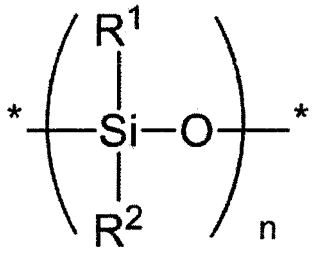

Formula (1)

In Formula (1), $R^1$ and $R^2$ each independently represent a hydrogen atom, a halogen atom, a monovalent organic group. Here, $R^1$, and $R^2$ may be the same as or different from each other. In addition, in a case where a plurality of $R^1$'s and $R^2$'s are present, $R^1$'s and $R^2$'s may be the same as or different from each other, respectively. n represents an integer of 1 or more.

A partial structure represented by "$-(Si(R^1)(R^2)-O)_n-$" which is a siloxane structural unit in the acrylic resin is a siloxane segment which can form various (poly)siloxane structures having a linear, branched, or cyclic structure.

In a case where $R^1$ and $R^2$ represent a halogen atom, examples of the halogen atom include a fluorine atom, a chlorine atom, and an iodine atom.

In a case where $R^1$ and $R^2$ represent a monovalent organic group, the monovalent organic group is not particularly limited as long as it is a group which can form a covalent bond with a Si atom. Examples of the monovalent organic group include an alkyl group (for example, a methyl group or an ethyl group), an aryl group (for example, a phenyl group), an aralkyl group (for example, a benzyl group or phenylethyl), an alkoxy group (for example, a methoxy group, an ethoxy group, or a propoxy group), an aryloxy group (for example, a phenoxy group), a mercapto group, an amino group (for example, an amino group or a diethylamino group), and an amido group. These organic groups may be unsubstituted or may have a substituent.

In particular, from the viewpoint of adhesiveness with an adjacent material such as the substrate film, $R^1$ and $R^2$ each independently represent preferably a hydrogen atom, a chlorine atom, a bromine atom, an unsubstituted alkyl group having 1 to 4 carbon atoms or a substituted alkyl group having 1 to 4 carbon atoms (in particular, a methyl group or an ethyl group), an unsubstituted phenyl group or a substituted phenyl group, an unsubstituted alkoxy group or a substituted alkoxy group, a mercapto group, an unsubstituted amino group, or an amido group, and more preferably an unsubstituted alkoxy group or a substituted alkoxy group (preferably an alkoxy group having 1 to 4 carbon atoms).

n represents preferably 1 to 5000 and more preferably 1 to 1000.

A ratio of the portion represented by "$-(Si(R^1)(R^2)-O)_n-$" (the (poly)siloxane structural unit represented by Formula (1)) in the acrylic resin to the total mass of the acrylic resin is preferably 15 mass% to 85 mass%. From the viewpoints of improving the strength of the first polymer layer, preventing damages caused by scratching, abrasion, or the like, and further improving adhesiveness with an adjacent material such as the substrate film, the ratio is more preferably 20 mass% to 80 mass%. In a case where the ratio of the (poly)siloxane structural unit is 15 mass% or higher, the strength of the first polymer layer is improved, damages caused by scratching, abrasion, or the like are prevented, adhesiveness with an adjacent material such as the substrate film is improved. In a case where the ratio of the (poly)siloxane structural unit is 85 mass% or lower, the coating solution can be stably held during the formation of the first polymer layer using a coating solution.

In a case where the binder polymer B is an acrylic resin having a (poly)siloxane structural unit (siloxane-containing acrylic resin), it is preferable that the mass ratio of the (poly)siloxane structural unit represented by Formula (1) included in a molecular chain is 15 mass% to 85 mass% and the mass ratio of a structural unit derived from acrylic acid or methacrylic acid included in a molecular chain is 85 mass% to 15 mass%. Due to the above-described copolymer configuration, the film hardness of the first polymer layer can be improved, damages caused by scratching, abrasion, or the like can be prevented, and adhesiveness with the substrate film can be significantly improved as compared to that of the related art. Further, in addition to these effects, durability in a hot humid environment can also be improved.

Examples of a method which can be used for preparing the siloxane-containing acrylic resin include: (i) a method of causing a homopolymer of a monomer for forming an acrylic resin to react with a polysiloxane having a structural unit represented by Formula (1); and (ii) a method of hydrolyzing and condensing a silane compound having a structural unit represented by Formula (1), in which $R^1$ and/or $R^2$ represents a hydrolyzable group, in the presence of a homopolymer or a copolymer of a monomer for forming an acrylic resin.

Examples of the silane compound used in the method (ii) include various silane compounds. Among these, an alkoxysilane compound is preferable.

In a case where the siloxane-containing acrylic resin is prepared using the method (i), for example, the siloxane-containing acrylic resin can be prepared by optionally adding water and a catalyst to a mixture including the homopolymer or the copolymer of the monomer for forming an acrylic resin and the polysiloxane, and causing them to react with each

other at a temperature of about 20°C to 150°C for about 30 minutes to 30 hours (preferably at 50°C to 130°C for 1 hour to 20 hours). As the catalyst, various silanol condensation catalysts such as an acidic compound, a basic compound, or a metal-containing compound can be added.

In a case where the polymer is prepared using the method (ii), for example, the polymer can be prepared by adding water and the silanol condensation catalyst to a mixture including the homopolymer or the copolymer of the monomer for forming an acrylic resin and the polysiloxane, and hydrolyzing and condensing them at a temperature of about 20°C to 150°C for about 30 minutes to 30 hours (preferably at 50°C to 130°C for 1 hour to 20 hours).

As the acrylic resin, a commercially available product may be used. Examples of the commercially available product of the acrylic resin include AS-563A (manufactured by Daicel FineChem Ltd.) and JURYMER (registered trade name) ET-410 and SEK-301 (both of which are manufactured by Nihon Junyaku Co., Ltd.). In addition, examples of the commercially available product of the siloxane-containing acrylic resin include CERANATE (registered trade name) series manufactured by DIC Corporation (for example, CERANATE (registered trade name) WSA1070 and WSA1060) and H7600 series manufactured by Asahi Kasei Chemicals Corporation (for example, H7650, H7630, and H7620), an inorganic acrylic composite emulsion manufactured by JSR Corporation, and SYMAC (registered trade name) series manufactured by Toagosei Co., Ltd. (for example, GS-30).

In particular, as the polymer in the first polymer layer, CERANATE (registered trade name) series manufactured by DIC Corporation, an inorganic acrylic composite emulsion manufactured by JSR Corporation, or SYMAC (registered trade name) manufactured by Toagosei Co., Ltd. is preferably used.

As the binder polymer B in the first polymer layer, the siloxane-containing acrylic resin may be used alone or in combination with another polymer. In a case where the siloxane-containing acrylic resin is used in combination with another polymer, a ratio of the content of the siloxane-containing acrylic resin to the total content of the binder is preferably 30 mass% or higher and more preferably 60 mass% or higher. By adjusting the content ratio of the siloxane-containing acrylic resin to be 30 mass% or higher, the strength of the first polymer layer is improved, damages caused by scratching, abrasion, or the like can be prevented, and adhesiveness with the substrate film and durability in a hot humid environment are further improved.

It is preferable that the content ratio of the siloxane-containing acrylic resin in the first polymer layer is preferably in a range of higher than 0.2 g/m$^2$ and 15 g/m$^2$ or lower. In a case where the content ratio of the siloxane-containing acrylic resin is in the above-described range, damages caused by an external force is suppressed, and the first polymer layer is sufficiently cured.

From the viewpoint of improving the surface strength of the first polymer layer, the content ratio of the siloxane-containing acrylic resin is preferably in a range of 0.5 g/m$^2$ to 10.0 g/m$^2$ and more preferably in a range of 1.0 g/m$^2$ to 7.0 g/m$^2$.

~Polyester Resin~

As the polyester resin, for example, polyethylene terephthalate (PET) or polyethylene-2,6-naphthalate (PEN) is preferable.

As the polyester resin, a commercially available product may be used. As the commercially available product, for example, VYLONAL (registered trade name) MD-1245 (manufactured by Toyobo Co., Ltd.) can be preferably used.

~Polyurethane Resin~

As the polyurethane, for example, a carbonate-based urethane resin is preferable. For example, SUPERFLEX (registered trade name) 460 (manufactured by DKS Co., Ltd.) can be preferably used.

~Polyolefin Resin~

As the polyolefin resin, for example, a modified polyolefin copolymer is preferable. As the polyolefin resin, a commercially available product may be used. Examples of the commercially available product include ARROW BASE (registered trade name) SE-1013N, SD-1010, TC-4010, and TD-4010 (all of which are manufactured by Unitika Ltd.), HITECH S3148, S3121, and S8512, (all of which are manufactured by Toho Chemical Industry Co., Ltd.), and CHEMIPEARL (registered trade name) S-120, S-75N, V100, and EV210H (all of which are manufactured by manufactured by Mitsui Chemicals, Inc.). Among these, ARROW BASE (registered trade name) SE-1013N (manufactured by Unitika Ltd.), which is a terpolymer of low-density polyethylene, acrylic acid ester, and maleic anhydride, is preferable from the viewpoint of improving adhesiveness with an adjacent layer.

In addition, an acid-modified polyolefin described in paragraphs "0022" to "0034" of JP2014-76632A can also be preferably used.

~Silicone Resin~

The silicone resin is a polymer having a (poly)siloxane structural unit in a molecular chain and is not particularly limited. The silicone resin may be a homopolymer of a compound having a (poly)siloxane structural unit, or a copolymer including a (poly)siloxane structural unit and another structural unit (which does not include a structural unit derived from acrylic acid or methacrylic acid). The other structural unit which is copolymerizable with a siloxane structural unit is a non-siloxane structural unit. As the (poly)siloxane structural unit, the above-described siloxane structural unit represented by Formula (1) is preferable.
It is preferable that the copolymer in the silicone resin is a block copolymer including the (poly)siloxane structural unit represented by Formula (1) and the non-siloxane structural unit, the block copolymer obtained by copolymerizing a siloxane compound (including polysiloxane) and a compound selected from a non-siloxane monomer and a non-siloxane polymer. In this case, as each of the siloxane compound and the non-siloxane monomer or the non-siloxane polymer which is copolymerizable with the siloxane compound, one kind may be used alone, or two or more kinds may be used.
The non-siloxane structural unit (derived from the non-siloxane monomer or the non-siloxane polymer) which is polymerizable with the (poly)siloxane structural unit is not particularly limited as long as it does not have a siloxane structure, and may be any polymer segment derived from an arbitrary polymer. Examples of a polymer (precursor polymer) which is a precursor of the polymer segment include various polymers such as a vinyl polymer (which does not include a homopolymer or a copolymer of the above-described monomer for forming an acrylic resin), a polyester polymer, or a polyurethane polymer.
Among these, from the viewpoint of easy preparation and excellent hydrolysis resistance, a vinyl polymer or a polyurethane polymer is preferable, and a vinyl polymer is more preferable.
Representative examples of the vinyl polymer include various polymers such as a vinyl carboxylate polymer, an aromatic vinyl polymer, or a fluoroolefin polymer.
As the polymer constituting the non-siloxane structural unit, one kind may be used, or a combination of two or more kinds may be used.
The precursor polymer can be manufactured using a method described in paragraphs "0021" to "0078" of JP2009-52011A, or is commercially available.

~Fluororesin~

The fluororesin is not particularly limited as long as it is a resin having a structural unit represented by $-(CFX^1-CX^2X^3)-$ (wherein $X^1$, $X^2$, and $X^3$, each independently represent a hydrogen atom, fluorine atom, a chlorine atom, or a perfluoroalkyl group having 1 to 3 carbon atoms).
Specific examples of the fluororesin include polytetrafluoroethylene (hereinafter, also referred to as "PTFE"), polyvinyl fluoride (hereinafter, also referred to as "PVF"), polyvinylidene fluoride (hereinafter, also referred to as "PVDF"), polychlorotrifluoroethylene (hereinafter, also referred to as "PCTFE"), and polytetrafluoropropylene (hereinafter, also referred to as "PTFP").
The fluororesin may be a homopolymer obtained by polymerization of one monomer, or a copolymer obtained by copolymerization of two or more monomers. Examples of the copolymer obtained by copolymerization of two or more monomers include a copolymer (abbreviated as P(TFE/TFP)) obtained by copolymerization of tetrafluoroethylene and tetrafluoropropylene, and a copolymer (abbreviated as P(TFE/VDF)) obtained by copolymerization of tetrafluoroethylene and vinylidene fluoride.
Further, the resin used in the first polymer layer including the fluororesin may be a resin obtained by copolymerization of a fluorine structural unit represented by $-(CFX^1-CX^2X^3)-$ and another structural unit. Examples of the resin include a copolymer of tetrafluoroethylene and ethylene (hereinafter, abbreviated as P(TFE/E)), a copolymer of tetrafluoroethylene and propylene (hereinafter, abbreviated as P(TFE/P)), a copolymer of tetrafluoroethylene and vinyl ether (hereinafter, abbreviated as P(TFE/VE)), a copolymer of tetrafluoroethylene and perfluorovinyl ether (hereinafter, abbreviated as P(TFE/FVE)), a copolymer of chlorotrifluoroethylene and vinyl ether (hereinafter, abbreviated as P(CTFE/VE)), and a copolymer of chlorotrifluoroethylene and perfluorovinyl ether (hereinafter, abbreviated as P(CTFE/FVE)).
The fluororesin may be used in the form of a solution in which a resin which is dissolved in an organic solvent or in the form of a water dispersion in which resin particles which are dispersed in water. From the viewpoint of environmental burden, the latter case is preferable. Regarding the water dispersion of the fluororesin, for example, fluororesins described in JP2003-231722A, JP2002-20409A, and JP1997-194538A (JP-H9-194538A) are applicable to the embodiment of the present invention.
Among the above-described polymers, the binder polymer B is preferably an acrylic resin and more preferably a siloxane-containing acrylic resin from the viewpoint of light fastness.
That is, it is preferable that the first polymer layer includes an ultraviolet absorbing acrylic resin as the polymer

A having an ultraviolet absorbing partial structure and includes an acrylic resin as the binder polymer B.

That is, it is more preferable that the first polymer layer includes an ultraviolet absorbing acrylic resin as the polymer A having an ultraviolet absorbing partial structure and includes a siloxane-containing acrylic resin as the binder polymer B.

From the viewpoint of light fastness, the weight-average molecular weight of the binder polymer B is preferably 5,000 to 200,000, more preferably 7,000 to 150,000, and still more preferably 10,000 to 100,000. The weight-average molecular weight can be measured using the above-described method.

The content of the binder polymer B in the first polymer layer is preferably 10 mass% to 80 mass%, more preferably 15 mass% to 75 mass%, and still more preferably 20 mass% to 70 mass% with respect to the solid content of the first polymer layer.

(Other Components)

Optionally, the first polymer layer further includes other components such as various additives, for example, a crosslinking agent, a crosslinking catalyst, a surfactant, a filler, or a light stabilizer.

Among these, from the viewpoint of further improving the strength of the first polymer layer and durability, it is preferable that a crosslinked structure derived from a crosslinking agent is formed in the first polymer layer by adding the crosslinking agent to the binder polymer B.

~Crosslinking Agent~

Examples of the crosslinking agent include an epoxy crosslinking agent, an isocyanate crosslinking agent, a melamine crosslinking agent, a carbodiimide crosslinking agent, and an oxazoline crosslinking agent. Among these, it is preferable that the crosslinking agent is at least one or more selected from the group consisting of a carbodiimide crosslinking agent, an oxazoline crosslinking agent, and an isocyanate crosslinking agent.

Examples of the oxazoline crosslinking agent include 2-vinyl-2-oxazoline, 2-vinyl-4-methyl-2-oxazoline, 2-vinyl-5-methyl-2-oxazoline, 2-isopropenyl-2-oxazoline, 2-isopropenyl-4-methyl-2-oxazoline, 2-isopropenyl-5-ethyl-2-oxazoline, 2,2'-bis-(2-oxazoline), 2,2'-methylene-bis-(2-oxazoline), 2,2'-ethylene-bis-(2-oxazoline), 2,2'-trimethylene-bis-(2-oxazoline), 2,2'-tetramethylene-bis-(2-oxazoline), 2,2'-hexamethylene-bis-(2-oxazoline), 2,2'-octamethylene-bis-(2-oxazoline), 2,2'-ethylene-bis-(4,4'-dimethyl-2-oxazoline), 2,2'-p-phenylene-bis-(2-oxazoline), 2,2'-m-phenylene-bis-(2-oxazoline), 2,2'-m-phenylene-bis-(4,4'-dimethyl-2-oxazoline), bis-(2-oxazolinylcyclohexane)sulfide, and bis-(2-oxazolinylnorbornane) sulfide. Further, a (co)polymer of the compound can also be preferably used.

In addition, as the oxazoline crosslinking agent, a commercially available product may be used. Examples of the commercially available product include EPOCROS (registered trade name) K-2010E, K-2020E, K-2030E, WS-500, and WS-700 (all of which are manufactured by Nippon Shokubai Co., Ltd.).

As the crosslinking agent, one kind may be used alone, or two or more kinds may be used in combination.

In a case where the crosslinking agent is used in the first polymer layer, the addition amount thereof is preferably 10 parts by mass to 40 parts by mass and more preferably 15 parts by mass to 35 parts by mass with respect to 100 parts by mass of the binder polymer B. In a case where the addition amount of the crosslinking agent is 10 parts by mass or more, a sufficient crosslinking effect can be obtained while maintaining the strength and adhesiveness of the weather-resistant layer. In a case where the content of the crosslinking agent is 40 parts by mass or less, a long pot life of the coating solution can be maintained. In a case where the content of the crosslinking agent is 35 parts by mass or less, the coating surface shape can be improved.

~Crosslinking Catalyst~

In a case where the first polymer layer includes a crosslinking agent, the crosslinking agent may be used in combination with a crosslinking catalyst. By the addition of the crosslinking catalyst, a crosslinking reaction between the resin component and the crosslinking agent is promoted, and solvent resistance is improved. In addition, since the crosslinking reaction progresses satisfactorily, the strength of an undercoat layer and dimension stability can be further improved.

In particular, in a case where a crosslinking agent having an oxazoline group (oxazoline crosslinking agent) is used as the crosslinking agent, it is preferable that the crosslinking catalyst is used.

Examples of the crosslinking catalyst include an onium compound.

Examples of the onium compound include an ammonium salt, a sulfonium salt, an oxonium salt, an iodonium salt, a phosphonium salt, a nitronium salt, a nitrosonium salt, and a diazonium salt.

Specific examples of the onium compound include:

an ammonium salt such as ammonium primary phosphate, ammonium secondary phosphate, ammonium chloride, ammonium sulfate, ammonium nitrate, ammonium p-toluenesulfonate, ammonium sulfamate, ammonium imidodisulfonate, tetrabutylammonium chloride, benzyltrimethylammonium chloride, triethylbenzylammonium chloride, tetrabutylammonium tetrafluoroborate, tetrabutylammonium hexaphosphate, tetrabutylammonium perchlorate, or tetrabutylammonium sulfate;
a sulfonium salt such as trimethylsulfonium iodide, trimethylsulfonium tetrafluoroborate, diphenylmethylsulfonium tetrafluoroborate, tetramethylenesulfonium tetrafluoroborate, antimony 2-butenyltetramethylenesulfonium hexafluoride, or antimony 3-methyl-2-butenyltetramethylenesulfonium hexafluoride;
an oxonium salt such as trimethyloxonium tetrafluoroborate;
an iodonium salt such as diphenyliodonium chloride or diphenyliodonium tetrafluoroborate;
a phosphonium salt such as antimony cyanomethyltributylphosphonium hexafluoride or ethoxycarbonylmethyltributylphosphonium tetrafluoroborate;
a nitronium salt such as nitronium tetrafluoroborate;
a nitrosonium salt such as nitrosonium tetrafluoroborate; and
a diazonium salt such as 4-methoxybenzenediazonium chloride.

Among these onium compounds, an ammonium salt, a sulfonium salt, an iodonium salt, or a phosphonium salt is more preferable, and an ammonium salt is still more preferable from the viewpoint of reactivity. From the viewpoints of pH and costs, a phosphoric acid compound or a benzyl chloride compound is preferable. It is still more preferable that the onium compound is ammonium secondary phosphate.
As the crosslinking catalyst, one kind may be used alone, or two or more kinds may be used in combination.
The addition amount of the crosslinking catalyst is preferably in a range of 0.1 mass% to 15 mass%, more preferably in a range of 0.5 mass% to 12 mass%, still more preferably in a range of 1 mass% to 10 mass%, and even still more preferably in a range of 2 mass% to 7 mass% with respect to the total solid content of the crosslinking agent. "The addition amount of the crosslinking catalyst is 0.1 mass% or higher with respect to the total solid content of the crosslinking agent" represents that the crosslinking catalyst is actively included. In this case, due to the addition of the crosslinking catalyst, a crosslinking reaction between the polymer as a binder having a yield point and the crosslinking agent progresses satisfactorily, and higher durability is obtained. In addition, it is preferable that the content of the crosslinking catalyst is 15 mass% or lower from the viewpoints of solubility, filtration properties of a coating solution, and adhesiveness with an adjacent layer.

~Surfactant~

Examples of the surfactant include a well-known surfactant such as an anionic surfactant or a nonionic surfactant. In a case where the surfactant is added, the addition amount thereof is preferably 0.1 $mg/m^2$ to 10 $mg/m^2$ and more preferably 0.5 $mg/m^2$ to 3 $mg/m^2$. In a case where the addition amount of the surfactant is 0.1 $mg/m^2$ or more, cissing is prevented, and a satisfactory layer can be formed. In a case where the addition amount of the surfactant is 10 $mg/m^2$ or less, adhesion with the substrate film or the like can be satisfactorily performed.

~Filler~

As the filler, a well-known filler such as silica particles can be used.
The details of the filler will be described below in [Second Polymer Layer].

~Light Stabilizer~

Examples of the light stabilizer include a well-known light stabilizer such as a hindered amine light stabilizer. As a commercially available product of the light stabilizer, for example, TINUVIN (registered trade name) 123-DW (manufactured by BASF SE), or UDOUBLE (registered trade name) E-771SI (manufactured by Nippon Shokubai Co., Ltd.) can be used. In a case where the light stabilizer is added, the addition amount thereof is preferably 0.1 $g/m^2$ to 5 $g/m^2$ and more preferably 0.3 $g/m^2$ to 3 $g/m^2$. In a case where the addition amount of the light stabilizer is 0.1 $g/m^2$ or more, excellent weather fastness can be obtained. In a case where the addition amount of the light stabilizer is 5 $g/m^2$ or more, bleed-out can be prevented.

Formation of First Polymer Layer

A method of forming the first polymer layer is not particularly limited. Examples of the method of forming the first polymer layer include a method of applying a coating solution including the polymer A having an ultraviolet absorbing

partial structure and the binder polymer B to one surface of the substrate film and drying the applied coating solution.

In the transparent sheet for a solar cell, it is preferable that the first polymer layer is a coating layer which is formed by applying an aqueous composition for forming the first polymer layer which includes the polymer A having an ultraviolet absorbing partial structure and the binder polymer B.

A coating method or a solvent used in the coating solution is not particularly limited. Examples of the coating method include a method using a gravure coater or a bar coater. The solvent used in the coating solution may be water or an organic solvent such as toluene or methyl ethyl ketone. From the viewpoint of environmental burden, it is preferable an aqueous coating solution including water as a solvent is prepared.

As the coating solvent, one kind may be used alone, or a mixture of two or more kinds may be used.

In a case where the first polymer layer is formed by dispersing the polymer A having an ultraviolet absorbing partial structure and the binder polymer B in water to form an aqueous coating solution and applying this coating solution, a ratio of the mass of water in the solvent to the total mass of the solvent is preferably 60 mass% or higher and more preferably 80 mass% or higher.

In addition, before forming the first polymer layer by coating, a surface treatment (for example, a flame treatment, a corona treatment, a plasma treatment, or an ultraviolet treatment) may be performed on the substrate film.

The first polymer layer may be disposed over the substrate film with another layer disposed therebetween (for example, an undercoat layer described below).

The thickness of the first polymer layer is preferably 0.1 μm to 30 μm, more preferably 0.5 μm to 25 μm, and still more preferably 1 μm to 15 μm.

In a case where the thickness of the first polymer layer is 0.1 μm or more, the function of the ultraviolet absorbing layer is more likely to be exhibited. In a case where the thickness of the first polymer layer is 30 μm or less, the transparency of the first polymer layer is further improved.

(Substrate Film)

The transparent sheet for a solar cell includes a substrate film.

As a material of the substrate film, a material having light-transmitting property can be appropriately selected. From the viewpoint of further increasing the effect of the first polymer layer improving light fastness, it is preferable that the material of the substrate film is a polymer. Examples of the polymer include a polyolefin resin such as polyester, polycarbonate, polypropylene, or polyethylene, and a fluorine polymer such as polyvinyl fluoride. Among these, polyester is preferable from the viewpoints of costs, mechanical strength, and light-transmitting property.

(Polyester)

Examples of the polyester include a linear saturated polyester which is synthesized from an aromatic dibasic acid or an ester-forming derivative thereof and diol or an ester-forming derivative thereof. Specific examples of the linear saturated polyester include polyethylene terephthalate, polyethylene isophthalate, polybutylene terephthalate, poly(1,4-cyclohexylenedimethylene terephthalate), and polyethylene-2,6-naphthalate. Among these, from the viewpoints of a good balance between mechanical properties and costs, polyethylene terephthalate, polyethylene-2,6-naphthalate, or poly(1,4-cyclohexylenedimethylene terephthalate) is more preferable.

The polyester may be a homopolymer or a copolymer. Further, in the polyester, a small amount of another resin such as polyimide may be mixed.

The kind of polyester is not particularly limited to the above description, and a well-known polyester may be used. The well-known polyester may be synthesized using a dicarboxylic acid component and a diol component, or may be commercially available.

In a case where the polyester is synthesized, the polyester can be obtained by performing at least one of an esterification reaction or an ester exchange reaction using a dicarboxylic acid component (a) and a diol component (b) with a well-known method.

Examples of the dicarboxylic acid component (a) include a dicarboxylic acid or an ester derivative, for example, an aliphatic dicarboxylic acid such as malonic acid, succinic acid, glutaric acid, adipic acid, suberic acid, sebacic acid, dodecanedioic acid, dimer acid, eicosadienoic acid, pimelic acid, azelaic acid, methylmalonic acid, or ethylmalonic acid; an alicyclic dicarboxylic acid such as adamantanedicarboxylic acid, norbornenedicarboxylic acid, cyclohexanedicarboxylic acid, or decalinedicarboxylic acid; and an aromatic dicarboxylic acid such as terephthalic acid, isophthalic acid, phthalic acid, 1,4-naphthalenedicarboxylic acid, 1,5-naphthalenedicarboxylic acid, 2,6-naphthalenedicarboxylic acid, 1,8-naphthalenedicarboxylic acid, 4,4'-diphenyldicarboxylic acid, 4,4'-diphenyletherdicarboxylic acid, sodium 5-sulfoisophthalic acid, phenylindanedicarboxylic acid, anthracenedicarboxylic acid, phenanthrenedicarboxylic acid, or 9,9'-bis(4-carboxyphenyl)fluorene acid.

(b) Examples of the diol component include a diol compound, for example, an aliphatic diol such as ethylene

glycol, 1,2-propanediol, 1,3-propanediol, 1,4-butanediol, 1,2-butanediol, or 1,3-butanediol; an alicyclic diol such as cyclohexanedimethanol, spiroglycol, or isosorbide; and an aromatic diol such as bisphenol A, 1,3-benzenedimethanol, 1,4-benzenedimethanol, or 9,9-bis(4-hydroxyphenyl)fluorene.

-CARBODIIMIDE COMPOUND, KETENIMINE COMPOUND-

A polyester film including polyester as a raw resin may include at least one of a carbodiimide compound or a ketenimine compound. Either the carbodiimide compound or the ketenimine compound may be used alone, or both of them may be used in combination. As a result, deterioration of polyester in a hot humid environment is prevented, and the use of the carbodiimide compound or the ketenimine compound is also effective for maintaining high insulating characteristics even in a hot humid environment.

The content of the carbodiimide compound or the ketenimine compound is preferably 0.1 mass% to 10 mass%, more preferably 0.1 mass% to 4 mass%, and still more preferably 0.1 mass% to 2 mass% with respect to the mass of the polyester. By adjusting the content of the carbodiimide compound or the ketenimine compound to be in the above-described range, adhesiveness between the substrate film and an adjacent layer can be further improved. In addition, the heat resistance of the substrate film can be improved.

In a case where the carbodiimide compound and the ketenimine compound are used in combination, it is preferable that the total content of the two compounds is in the above-described range.

(Polycarbonate)

Examples of the polycarbonate include diol polycarbonate. The diol polycarbonate is produced through a reaction such as a methanol removal condensation reaction of dialcohol and dimethyl carbonate, a phenol removal condensation reaction of dialcohol and diphenyl carbonate, or an ethylene removal condensation reaction of dialcohol and ethylene carbonate. Examples of the polyhydric alcohol used in the above-described reaction include: various saturated or unsaturated glycols such as 1,6-hexanediol, diethylene glycol, triethylene glycol, propylene glycol, 1,3-butanediol, 1,4-butanediol, neopentylglycol, pentanediol, 3-methyl-1,5-pentanediol, octanediol, 1,4-butynediol, dipropylene glycol, tripropylene glycol, or polytetramethylene ether glycol; and an alicyclic glycol such as 1,4-cyclohexane glycol or 1,4-cyclohexanedimethanol.

Preparation of Substrate Film

A method of preparing the substrate film is not particularly limited, and examples thereof include a method including: a step of stretching a non-stretched film in a first direction; a step of optionally applying an undercoat layer-forming composition described below to one surface of the film which is stretched in the first direction; a step of stretching the uniaxially stretched film in a second direction perpendicular to the first direction; and a heat fixing step of performing a heat fixing treatment (for example, a heat treatment at a temperature of 165°C to 240°C) on the stretched film.

(Step of Stretching Non-Stretched Film in First Direction)

In this step, a non-stretched film is stretched in a first direction.

The non-stretched film can be obtained by drying the above-described polyester as a raw material, melting the dried polyester, causing the obtained melt to pass through a gear pump or a filter, extruding the melt into a cooling roll through a die, and cooling and solidifying the extruded polyester. The polyester is melted using an extruder. In this case, a single-screw extruder or a twin-screw extruder may be used.

It is preferable that the molten polyester is extruded in a vacuum environment or an inert gas atmosphere. The temperature of the extruder is preferably (a melting point of the polyester used) to (the melting point+80°C), more preferably (the melting point+10°C) to (the melting point+70°C), and still more preferably (the melting point+20°C) to (the melting point+60°C). It is preferable that the temperature of the extruder is (the melting point+10°C) or higher because the polyester can be sufficiently melted. On the other hand, it is preferable that the temperature of the extruder is (the melting point+70°C) or lower because decomposition of polyester or the like is prevented. It is preferable that the raw resin of the polyester is dried in advance before the extrusion, and the moisture content of the polyester is preferably 10 ppm to 300 ppm, and more preferably 20 ppm to 150 ppm.

During the melting of the raw resin, at least one of a ketenimine compound or a carbodiimide compound may be added in order to improve the hydrolysis resistance of the non-stretched film

The carbodiimide compound or the ketenimine compound may be added directly to the extruder. However, from the viewpoint of extrusion stability, it is preferable that the polyester and a master batch are formed and put into the extruder. In a case where the master batch is formed, it is preferable that the supply amount of the master batch

including the ketenimine compound is caused to vary. It is preferable that the ketenimine concentration in the master batch is high. From the viewpoint of costs, the ketenimine concentration in the prepared sheet is preferably 2 times to 100 times, and more preferably 5 times to 50 times.

The extruded melt is cast on a cast drum through a gear pump, a filter, and a multi-layer die. As a type of the multi-layer die, any one of a multi manifold die and a feed block die can be preferably used. As a shape of the die, any one of a T-die, a hanger coat die, and a fishtail die may be used. It is preferable that the temperature of a tip end (die lip) of the die is caused to vary. On the cast drum, the melt can be caused to adhere to the cooling roll using an electrostatic application method. At this time, it is preferable that the driving speed of the cast drum is caused to vary. The surface temperature of the cast drum can be made to be about 10°C to 40°C. The diameter of the cast drum is preferably 0.5 m to 5 m and more preferably 1 m to 4 m. The driving speed of the cast drum (linear speed of the outer circumference) is preferably 1 m/min to 50 m/min and more preferably 3 m/min to 30 m/min.

It is preferable that the non-stretched film which is formed using the above-described forming method or the like undergoes a stretching treatment. It is preferable that the stretching treatment is performed in either a machine direction (MD) or a transverse direction (TD). The stretching treatment may be any one of MD stretching and TD stretching.

During the stretching treatment, the temperature is preferably a glass temperature (Tg; unit: °C) of the film to (Tg+60°C), more preferably (Tg+3°C) to (Tg+40°C), and still more preferably (Tg+5°C) to (Tg+30°C). At this time, it is preferable that a temperature distribution is generated.

A stretching ratio in at least either the MD stretching or the TD stretching is preferably 270% to 500%, more preferably 280% to 480%, and still more preferably 290% to 460%. The stretching ratio is obtained using the following expression.

$$\text{Stretching Ratio (\%)}=100\times\{\text{Length after Stretching})/(\text{Length before Stretching})\}$$

Through the above-described steps, an uniaxially stretched film which is stretched in the first direction is manufactured.

(Step of Applying Undercoat Layer-Forming Composition)

Next, optionally, an undercoat layer-forming composition described below is applied to one surface of the film which is stretched in the first direction.

Coating is preferable from the viewpoint that a thin film having high uniformity can be simply formed. Examples of the coating method include a well-known method using a gravure coater or a bar coater. A solvent of the undercoat layer-forming composition used for coating may be water or an organic solvent such as toluene or methyl ethyl ketone. As the solvent, one kind may be used alone, or a mixture of two or more kinds may be used.

It is preferable that the undercoat layer-forming composition is applied to the uniaxially stretched film using a so-called in-line coating method in which the application is performed after the step of stretching a non-stretched film in a first direction.

It is preferable that a surface treatment such as a corona discharge treatment, a glow treatment, an atmospheric pressure plasma treatment, a flame treatment, or a UV treatment is performed on the uniaxially stretched film before the application of the undercoat layer-forming composition.

It is preferable that a step of drying the coating film is provided after the application of the undercoat layer-forming composition. In the drying step, dry air is supplied to the coating film. The average wind speed of the dry air is preferably 5 m/sec to 30 m/sec, more preferably 7 m/sec to 25 m/sec, and still more preferably 9 m/sec to 20 m/sec.

It is preferable that a heat treatment is also performed during the drying of the coating film.

(Step of Stretching Uniaxially Stretched Film in Second Direction)

It is preferable that the film to which the undercoat layer-forming composition is optionally applied is further stretched in a second direction perpendicular to the first direction along the film surface.

By stretching the film in the second direction, the uniaxially stretched film is stretched together with the undercoat layer-forming composition, and a film including the undercoat layer (in-line coating layer) is formed.

The stretching treatment can be performed in the machine direction (MD) or the transverse direction (TD) as long as the second direction is perpendicular to the first direction.

A preferable aspect of the step of stretching the uniaxially stretched film in the second direction is the same as that of the step of stretching a non-stretched film in a first direction.

(Heat Fixing Step)

It is preferable that a heat fixing treatment is performed on the biaxially stretched film.

In the heat fixing step, it is preferable that a heat treatment is performed on the film at a temperature of preferably 165°C to 240°C and more preferably 175°C to 230°C (still more preferably 185°C to 220°C) for preferably 1 second to 60 seconds (more preferably 2 seconds to 30 seconds).

In a case where the film is a polyester film, the heat fixing temperature in the heat fixing step is determined as a small peak temperature derived from a heat fixing temperature of the biaxially stretched polyester film which is measured by differential scanning calorimetry (DSC). That is, in a case where the heat fixing temperature is 165°C or higher, the crystallinity of the polyester film is high, and the weather fastness of a transparent sheet for a solar cell which is formed using the polyester film is excellent. In a case where the heat fixing temperature is 240°C or lower, the molecular orientation of the polyester film is highly ordered. Therefore, the weather fastness of a transparent sheet for a solar cell which is formed using the polyester film is excellent. The heat fixing temperature described herein refers to a film surface temperature during the heat fixing treatment.

In the heat fixing step which is provided after the stretching step, a part of a volatile basic compound having a boiling point of 200°C or lower may be volatilized.

It is preferable that the heat fixing step is performed after the TD stretching in a state where the film is held between chucks in a tenter. At this time, the distance between the chucks may be the same as the width at the end of the TD stretching, or may be longer or shorter than the width. By performing the heat fixing treatment, microcrystals can be formed, and mechanical properties and durability can be improved.

It is preferable that a heat relaxation step is performed after the heat fixing step. The heat relaxation step refers to a step in which heat is applied to the film for stress relaxation such that the film shrinks. In the heat relaxation step, it is preferable that the relaxation treatment is performed in at least one of the MD direction or the TD direction. The amount of relaxation in both the MD direction and the TD direction is preferably 1% to 15% (with respect to the width after the TD stretching), more preferably 2% to 10%, and still more preferably 3% to 8%. The relaxation temperature is preferably (Tg+50°C) to (Tg+180°C), more preferably (Tg+60°C) to (Tg+I50°C), and still more preferably (Tg+70°C) to (Tg+140°C).

In a case where the melting point of the film is represented by Tm, the relaxation temperature in the heat relaxation step is preferably (Tm-100°C) to (Tm-10°C), more preferably (Tm-80°C) to (Tm-20°C), and still more preferably (Tm-70°C) to (Tm-35°C). As a result, for example, in the case of a polyester film, the formation of crystals is promoted, and mechanical strength and heat shrinkability can be improved. Further, hydrolysis resistance is improved by performing the heat relaxation treatment at (Tm-35°C) or lower. The reason for this is to reduce the reactivity with water by increasing the tension (restriction) without disturbing the orientation of an amorphous portion where hydrolysis is likely to occur.

The TD relaxation can be performed by reducing the width of clips in a tenter. In addition, the MD relaxation can be performed by reducing the distance between clips adjacent to a tenter. The MD relaxation can be performed by linking the clips adjacent to the tenter in a pantagraph shape and reducing this pantagraph. In addition, the relaxation can be performed by taking the film out from the tenter and then performing the heat treatment while transporting the film at a low tension. The tension per cross-sectional area of the film is preferably 0 $N/mm^2$ to 0.8 $N/mm^2$, more preferably 0 $N/mm^2$ to 0.6 $N/mm^2$, and still more preferably 0 $N/mm^2$ to 0.4 $N/mm^2$. The relaxation can be performed at a tension of 0 $N/mm^2$ by providing two pairs of nip rolls during the transport and loosening the tension between the nip rolls (in a suspended state).

Regarding the film which is taken out from the tenter, opposite ends thereof which are held by the clips are trimmed and then are knurled. Next, the film is wound. The width is preferably 0.8 m to 10 m, more preferably 1 m to 6 m, and still more preferably 1.5 m to 4 m. The thickness is preferably 30 μm to 500 μm, more preferably 40 μm to 450 μm, and still more preferably 45 μm to 400 μm. The thickness can be adjusted as described above by adjusting the jetting amount of the extruder or the film forming rate (for example, the speed of the cooling roll or the stretching rate corresponding thereto).

[Second Polymer Layer]

It is preferable that the transparent sheet for a solar cell further includes a second polymer layer that is provided on the first polymer layer and includes a filler.

Since the transparent sheet for a solar cell includes the second polymer layer that is provided on the first polymer layer, scratch resistance can be improved.

It is preferable that the second polymer layer is provided on a surface of the transparent sheet for a solar cell opposite to the surface to which a solar cell adheres, and in a case where a solar cell module is manufactured using the transparent sheet for a solar cell, it is preferable that the second polymer layer is disposed as the outermost layer.

(Filler)

The filler is not particularly limited as long as the transparency of the second polymer layer can be maintained. Examples of the filler include silica particles.

~Silica Particles~

Examples of the silica particles include fumed silica and colloidal silica.

The fumed silica can be obtained by causing a compound including a silicon atom to react with oxygen and hydrogen in a gas phase. Examples of the silicon compound as the raw material include silicon halide (for example, silicon chloride).

The colloidal silica can be synthesized using a sol-gel method in which a raw material compound is hydrolyzed and condensed. Examples of the raw material compound of the colloidal silica include alkoxy silicon (for example, tetraethoxysilane) and a halogenated silane compound (for example, diphenyldichlorosilane).

The shape of the silica particles is not particularly limited, and examples thereof include a spherical shape, a plate shape, a needle shape, a bead shape, and a combination of two or more kinds thereof. The spherical shape refers not only to a true spherical shape but also to a spheroidal shape or an oval shape.

From the viewpoint of the transparency of the second polymer layer, the volume average particle size of the silica particles is preferably 1 nm to 100 nm, more preferably 1 nm to 50 nm, and still more preferably 1 nm to 30 nm.

The volume average particle size can be measured using a particle size distribution analyzer (MT-3300, manufactured by Nikkiso Co., Ltd.) with a dynamic light scattering method or a static light scattering method.

As the silica particles, a commercially available product may be used. Examples of the commercially available product include SNOWTEX (registered trade name) series manufactured by Nissan Chemical Industries Ltd., CATALOID (registered trade name)-S series manufactured by JGC C&C, and LEVASIL series manufactured by Bayer Holding Ltd.

Specific examples include SNOWTEX (registered trade name) ST-20, ST-30, ST-40, ST-C, ST-N, ST-20L, ST-O, ST-OL, ST-S, ST-XS, ST-XL, ST-YL, ST-ZL, ST-OZL, and ST-AK (all of which are manufactured by Nissan Chemical Industries Ltd.), SNOWTEX (registered trade name) AK series, SNOWTEX (registered trade name) PS series, and SNOWTEX (registered trade name) UP series.

From the viewpoints of scratch resistance and transparency, the content of the filler in the second polymer layer is preferably 0.01 mass% to 5 mass%, more preferably 0.05 mass% to 2 mass%, and still more preferably 0.1 mass% to 1 mass% with respect to the solid content of the second polymer layer.

(Binder Polymer)

It is preferable that the second polymer layer includes a binder polymer.

Examples of the binder polymer include the binder polymer B in the first polymer layer and the exemplary polymers described regarding the binder polymer B in the first polymer layer.

In a case where the second polymer layer includes a binder polymer and is disposed on the first polymer layer, the binder polymer included in the second polymer layer may be the same as or different from the binder polymer B included in the first polymer layer.

As the binder polymer in the second polymer layer, a fluororesin is preferable from the viewpoints of scratch resistance and light fastness.

~Fluororesin~

The fluororesin is not particularly limited as long as it is a resin having a structural unit represented by $-(CFX^1-CX^2X^3)-$ (wherein $X^1$, $X^2$, and $X^3$, each independently represent a hydrogen atom, fluorine atom, a chlorine atom, or a perfluoroalkyl group having 1 to 3 carbon atoms).

Specific examples and preferable examples of the fluororesin used in the second polymer layer are the same as those of the fluororesin which can be used as the binder polymer B in the first polymer layer.

In order to form the second polymer layer, the fluororesin may be dissolved in an organic solvent and used, or fluororesin particles may be dispersed in an appropriate dispersion medium such as water and used. From the viewpoint of reducing environmental burden, it is preferable that the fluororesin is used in the form of a dispersion in which water or an aqueous solvent is used as a dispersion medium. Regarding the water dispersion of the fluororesin, for example, fluororesins described in JP2003-231722A, JP2002-20409A, and JP1997-194538A (JP-H9-194538A) are applicable to the embodiment of the present invention and may be used to form the second polymer layer.

As the second polymer layer, one fluororesin may be used alone, or two or more fluororesins may be used in combination. In addition, the fluororesin may be used in combination with a resin other than a fluororesin such as an

acrylic resin, a polyester resin, a polyurethane resin, a polyolefin resin, or a silicone resin as long as the content thereof is not higher than 50 mass% with respect to the total mass of the binder polymer. In a case where the second polymer layer is used as a transparent sheet by including 50 mass% of the fluororesin, the effect of improving light fastness can be exhibited more satisfactorily.

(Polymer having Ultraviolet absorbing partial structure)

It is preferable that the second polymer layer includes a polymer having an ultraviolet absorbing partial structure.
Examples of the polymer having an ultraviolet absorbing partial structure are the same as the exemplary polymers described above regarding the polymer A having an ultraviolet absorbing partial structure in the first polymer layer.
In a case where the second polymer layer includes a polymer having an ultraviolet absorbing partial structure and is disposed on the first polymer layer, the polymer having an ultraviolet absorbing partial structure included in the second polymer layer may be the same as or different from the polymer having an ultraviolet absorbing partial structure included in the first polymer layer.
Since the second polymer layer includes a polymer having an ultraviolet absorbing partial structure, the light fastness of the transparent sheet for a solar cell can be further improved.

(Lubricant)

It is preferable that the second polymer layer includes at least one lubricant.
Since the second polymer layer includes a lubricant, deterioration in lubricating properties (that is, an increase in dynamic friction coefficient), which is likely to occur in a case where the fluororesin is used, is prevented. Therefore, scratch resistance against an external force such as scratching, abrasion, or collision with gravel or the like can be significantly improved. In addition, the surface cissing of the coating solution, which is likely to occur in a case where the fluororesin is used, can be improved, and the second polymer layer which includes a fluororesin having an excellent surface shape can be formed.
It is preferable that the second polymer layer includes the lubricant in a range of 0.2 mg/$m^2$ to 200 mg/$m^2$. In a case where the content ratio of the lubricant is 0.2 mg/$m^2$ or higher, the effect of reducing the dynamic friction coefficient is high. In addition, in a case where the content ratio of the lubricant is 200 mg/$m^2$ or lower, when the second polymer layer is formed by coating, coating unevenness or the formation of an aggregate is likely to occur, and cissing is likely to be prevented.
From the viewpoint of the effect of reducing the dynamic friction coefficient and the coating aptitude, the content ratio of the lubricant is preferably in a range of 1.0 mg/$m^2$ to 1150 mg/$m^2$ and more preferably in a range of 5.0 mg/$m^2$ to 100 mg/$m^2$.
Examples of the lubricant include a synthetic wax compound, a natural wax compound, a surfactant compound, an inorganic compound, and an organic resin compound. Among these, a compound selected from the group consisting of a synthetic wax compound, a natural wax compound, and a surfactant compound is preferable from the viewpoint of the surface strength of the polymer layer.
Examples of the synthetic wax compound include: an olefin wax such as a polyethylene wax or a polypropylene wax; an ester such as stearic acid, oleic acid, erucic acid, lauric acid, behenic acid, palmitic acid, or adipic acid; an amide, a bisamide, a ketone, a metal salt, or a derivative thereof; a synthetic hydrocarbon wax such as a Fischer-Tropsch wax; and a hydrogenated wax such as phosphoric acid ester, hardened castor oil, or a hardened castor oil derivative.
Examples of the natural wax compound include: a plant wax such as carnauba wax, candelilla wax, or Japan wax; a petroleum wax such as paraffin wax or microcrystalline wax; a mineral wax such as montan wax; and an animal wax such as a beeswax or lanolin.
Examples of the surfactant compound include: a cationic surfactant such as an alkyl amine salt; an anionic surfactant such as an alkylsulfuric acid ester salt; a nonionic surfactant such as polyoxyethylene alkyl ether, an amphoteric surfactant such as an alkyl betaine, and a fluorine surfactant.
As the lubricant, a commercially available product may be used.
Specific examples of the synthetic wax lubricant include: CHEMIPEARL (registered trade name) series manufactured by Mitsui Chemicals, Inc. (for example, CHEMIPEARL (registered trade name) W700, CHEMIPEARL W900, and CHEMIPEARL W950); and POLYRON P-502, HYMICRON L-271, and HIDORIN L-536 manufactured by Chukyo Yushi Co., Ltd.
Examples of the natural wax lubricant include HIDORIN L-703-35, SELOSOL 524, and SELOSOL R-586 manufactured by Chukyo Yushi Co., Ltd.
Examples of the surfactant lubricant include NIKKOL (registered trade name) series manufactured by Nikko Chemicals Co., Ltd. (for example, NIKKOL (registered trade name) SCS) and EMAL (registered trade name) series

manufactured by Kao Corporation (for example, EMAL (registered trade name) 40).

In particular, in the second polymer layer, it is preferable that OBBLIGATO (registered trade name) series manufactured by AGC Coat-Tech Co., Ltd., CERANATE (registered trade name) series manufactured by DIC Corporation, or an inorganic acrylic composite emulsion manufactured by JSR Corporation is used as the binder polymer, and that CHEMIPEARL (registered trade name) series manufactured by Mitsui Chemicals, Inc. is used as the lubricant.

(Other Additives)

Optionally, a silane coupling agent, a crosslinking agent, a surfactant, and the like may be added to the second polymer layer.

By adding the silane coupling agent to the second polymer layer, the surface shape of the second polymer layer is further improved.

As the silane coupling agent, an alkoxysilane compound is preferable, and examples thereof include tetraalkoxysilane, and trialkoxysilane. Among these, trialkoxysilane is preferable, and an alkoxysilane compound having an amino group is more preferable.

The content of the silane coupling agent is preferably 0.3 mass% to 1.0 mass% and more preferably 0.5 mass% to 0.8 mass% with respect to the solid content of the second polymer layer.

By adjusting the content of the silane coupling agent to be 0.3 mass% or higher, the effect of improving the surface shape is excellent. By adjusting the content of the silane coupling agent to be 1.0 mass% or lower, in a case where a layer is formed using a coating solution, the aggregation of the coating solution can be prevented.

From the viewpoint of improving weather fastness, it is preferable that the crosslinking agent is added to the second polymer layer to form a crosslinked structure. Examples of the crosslinking agent used in the second polymer layer are the same as the examples described above regarding the crosslinking agent used in the first polymer layer.

As the surfactant used in the second polymer layer, a well-known surfactant such as an anionic surfactant or a nonionic surfactant can be used. In a case where the surfactant is added, the addition amount thereof is preferably 0 $mg/m^2$ to 15 $mg/m^2$ and more preferably 0.5 $mg/m^2$ to 5 $mg/m^2$. In a case where the addition amount of the surfactant is 0.1 $mg/m^2$ or more, cissing is suppressed, and an excellent layer is obtained. In a case where the addition amount of the surfactant is 15 $mg/m^2$ or less, adhesion can be satisfactorily performed.

Formation of Second Polymer Layer

A method of forming the second polymer layer is not particularly limited. Examples of the method of forming the second polymer layer include a method of applying a coating solution including the filler, the binder polymer, and the like to the first polymer layer and drying the applied coating solution.

In the transparent sheet for a solar cell, it is preferable that the second polymer layer is a coating layer which is formed by applying an aqueous composition for forming the second polymer layer including the filler and the binder polymer.

A coating method or a solvent used in the coating solution is not particularly limited. Examples of the coating method include a method using a gravure coater or a bar coater. The solvent used in the coating solution may be water or an organic solvent such as toluene or methyl ethyl ketone. From the viewpoint of environmental burden, it is preferable an aqueous coating solution including water as a solvent is prepared.

As the solvent used for the coating solution, one kind may be used alone, or a mixture of two or more kinds may be used.

In a case where an aqueous coating solution obtained by dispersing the filler in water is applied to form the second polymer layer, the proportion of water in the solvent is preferably 60 mass% or higher and more preferably 80 mass% or higher.

From the viewpoints of scratch resistance and transparency, the thickness of the second polymer layer is preferably 0.1 $\mu m$ to 10 $\mu m$, more preferably 0.3 $\mu m$ to 5 $\mu m$, and still more preferably 0.5 $\mu m$ to 3 $\mu m$.

In the transparent sheet for a solar cell, it is preferable that the substrate film, the first polymer layer, and the second polymer layer are laminated in this order.

Another layer may be further laminated on the second polymer layer (a surface thereof opposite to the surface where the first polymer layer is laminated). However, from the viewpoints of the improvement in the scratch resistance of the transparent sheet for a solar cell, light-transmitting property, a reduction in weight, a reduction in thickness, and low costs, it is preferable that the second polymer layer is the outermost layer of the transparent sheet for a solar cell.

[Third Polymer Layer]

It is preferable that the transparent sheet for a solar cell further includes a third polymer layer that is provided

on a surface of the substrate film opposite to the surface, where the first polymer layer is disposed, and includes the polymer A having an ultraviolet absorbing partial structure and a binder polymer C described below.

The third polymer layer includes the polymer A having an ultraviolet absorbing partial structure. As a result, in a case where a solar cell module is manufactured using this transparent sheet for a solar cell, ultraviolet light incident from the solar cell module side can be absorbed, and deterioration of the substrate film in the transparent sheet for a solar cell can be prevented. That is, the third polymer layer functions as an ultraviolet absorbing layer that absorbs ultraviolet light incident from the solar cell module side.

The polymer A having an ultraviolet absorbing partial structure in the third polymer layer is the same as the polymer A having an ultraviolet absorbing partial structure described above regarding the first polymer layer, and a preferable aspect thereof is also the same.

Examples of the binder polymer C include an acrylic resin, a polyester resin, a polyurethane resin, and a polyolefin resin which are the examples described above regarding the binder polymer B.

From the viewpoint of adhesiveness with a sealing material in a solar cell module which is manufactured using the transparent sheet for a solar cell, as the binder polymer C, an acrylic resin is preferable, and an acrylic resin having a styrene skeleton is more preferable.

That is, it is preferable that the third polymer layer includes an ultraviolet absorbing acrylic resin as the polymer A having an ultraviolet absorbing partial structure and includes an acrylic resin as the binder polymer C.

In a case where the transparent sheet for a solar cell includes the first polymer layer and the third polymer layer, the polymers A having an ultraviolet absorbing partial structure included in the respective layers may be the same as or different from each other. In addition, the binder polymer B and the binder polymer C may be the same as or different from each other.

In a case where the transparent sheet for a solar cell includes the first polymer layer and the third polymer layer, it is preferable that the first polymer layer includes an ultraviolet absorbing acrylic resin as the polymer A having an ultraviolet absorbing partial structure and includes an acrylic resin as the binder polymer B, and it is preferable that the third polymer layer includes an ultraviolet absorbing acrylic resin as the polymer A having an ultraviolet absorbing partial structure and includes an acrylic resin as the binder polymer C.

Regarding a method of laminating the third polymer layer, it is preferable that the third polymer layer is laminated by applying a composition in which a resin component in the third polymer layer is dissolved in an organic solvent or is dispersed in water.

In addition to the resin component and the solvent or the dispersion medium, optionally, other additives may be added to the composition used for forming the third polymer layer.

The other additives can be selected depending on a function which is imparted to the third polymer layer, and examples thereof include a crosslinking agent for improving the film hardness, a surfactant for improving the uniformity of the coating film, an antioxidant, and a preservative.

The binder polymer C included in the third polymer layer may be crosslinked by the crosslinking agent. By forming a crosslinked structure in the third polymer layer, adhesiveness with an adjacent layer can be further improved. Examples of the crosslinking agent include an epoxy crosslinking agent, an isocyanate crosslinking agent, a melamine crosslinking agent, a carbodiimide crosslinking agent, and an oxazoline crosslinking agent which are the examples described above regarding the first polymer layer.

In a case where a crosslinking agent is used in the third polymer layer, the crosslinking agent may be used in combination with a crosslinking catalyst. By the addition of the crosslinking catalyst, a crosslinking reaction between the resin component and the crosslinking agent is promoted, and solvent resistance is improved. In addition, the crosslinking reaction progresses satisfactorily, and adhesiveness between the third polymer layer and an adjacent layer is further improved.

In particular, in a case where a crosslinking agent having an oxazoline group (oxazoline crosslinking agent) is used as the crosslinking agent, it is preferable that the crosslinking catalyst is used.

Examples of the crosslinking catalyst include an onium compound.

Examples of the onium compound include an ammonium salt, a sulfonium salt, an oxonium salt, an iodonium salt, a phosphonium salt, a nitronium salt, a nitrosonium salt, and a diazonium salt.

As the crosslinking catalyst, the exemplary compounds described above regarding the first polymer layer can be used, and preferable examples are also the same.

From the viewpoint of improving adhesiveness, it is preferable that the thickness of the third polymer layer is more than the thickness of a fourth polymer layer as an easily adhesive layer described below. That is, in a case where the thickness of the third polymer layer is represented by (b) and the thickness of the fourth polymer layer is represented by (c), it is preferable that a relationship of (b)>(c) is satisfied, and it is more preferable that (b):(c) is in a range of 2:1 to 15:1.

In addition, the thickness of the third polymer layer is preferably 0.5 $\mu$m or more, and more preferably 0.7 $\mu$m or more. In addition, it is preferable that the thickness of the third polymer layer is 7.0 $\mu$m or less.

In a case where the thickness of the third polymer layer and a balance between the thickness of the third

polymer layer and the thickness of the fourth polymer layer are in the above-described range, properties of the film of the resin component which forms the third polymer layer are exhibited satisfactorily, and adhesiveness between the transparent sheet for a solar cell and a sealing material and durability are further improved.

Formation of Third Polymer Layer

Examples of a method of forming the third polymer layer include a coating method. The coating method is preferable from the viewpoint that a thin film having high uniformity can be simply formed. As the coating method, for example, a well-known method using a gravure coater or a bar coater can be used.

In a case where the third polymer layer is formed by coating, it is preferable that a heat treatment is also performed during the drying of the coating film in a drying zone.

It is preferable that a step of drying the coating film is provided after the application of the composition for forming the third polymer layer. In the drying step, dry air is supplied to the coating film. The average wind speed of the dry air is preferably 5 m/sec to 30 m/sec, more preferably 7 m/sec to 25 m/sec, and still more preferably 9 m/sec to 20 m/sec.

[Fourth Polymer Layer]

It is preferable that the transparent sheet for a solar cell further includes a fourth polymer layer that is provided on the third polymer layer.

In a case where the transparent sheet for a solar cell is used, the fourth polymer layer functions as a layer which is in direct contact with a sealing material of a solar cell module, that is, an easily adhesive layer for a sealing material of a solar cell module.

The fourth polymer layer includes at least a resin component and, optionally, may further include various additives.

Examples of the resin component in the fourth polymer layer include at least one resin selected from the group consisting of a polyolefin resin, an acrylic resin, a polyester resin, and a polyurethane resin. The above-described resin is preferably used because an adhesive strength can be easily obtained. Specifically, for example, the following resins can be used.

The acrylic resin is not particularly limited as long as it is a resin having a structural unit derived from acrylic acid or methacrylic acid. As the acrylic resin, an acrylic resin including polymethyl methacrylate or polyethyl acrylate is preferable. As the acrylic resin, a commercially available product may be used. Examples of the commercially available product of the acrylic resin include AS-563A (manufactured by Daicel FineChem Ltd.) and JURYMER (registered trade name) ET-410 and SEK-301 (both of which are manufactured by Nihon Junyaku Co., Ltd.).

In addition, as the acrylic resin, a siloxane-containing acrylic resin can also be used. As the siloxane-containing acrylic resin, a commercially available product may be used. Examples of the commercially available product include CERANATE (registered trade name) WSA1060 and WSA1070 (both of which are manufactured by DIC Corporation) and H7620, H7630, and H7650 (both of which are manufactured by Asahi Kasei Chemicals Corporation).

As the polyester resin, for example, polyethylene terephthalate (PET) or polyethylene-2,6-naphthalate (PEN) is preferable. As the polyester resin, a commercially available product may be used. For example, VYLONAL (registered trade name) MD-1245 (manufactured by Toyobo Co., Ltd.) can be preferably used.

As the polyurethane resin, for example, a carbonate-based urethane resin is preferable. For example, SUPERFLEX (registered trade name) 460 (manufactured by DKS Co., Ltd.) can be preferably used.

As the polyolefin resin, for example, a modified polyolefin copolymer is preferable. As the polyolefin resin, a commercially available product may be used. Examples of the commercially available product include ARROW BASE (registered trade name) SE-1013N, SD-1010, TC-4010, and TD-4010 (all of which are manufactured by Unitika Ltd.), HITECH S3148, S3121, and S8512, (all of which are manufactured by Toho Chemical Industry Co., Ltd.), and CHEMIPEARL (registered trade name) S-120, S-75N, V100, and EV210H (all of which are manufactured by manufactured by Mitsui Chemicals, Inc.). Among these, ARROW BASE (registered trade name) SE-1013N (manufactured by Unitika Ltd.), which is a terpolymer of low-density polyethylene, acrylic acid ester, and maleic anhydride, is preferable from the viewpoint of improving adhesiveness.

As the polyolefin resin, one kind may be used, or two or more kinds may be used. In a case where a combination of two or more polyolefin resins is used, a combination of an acrylic resin and a polyolefin resin, a combination of a polyester resin and a polyolefin resin, and a combination of a polyurethane resin and a polyolefin resin is preferable, and a combination of an acrylic resin and a polyolefin resin is more preferable.

That is, it is preferable that the transparent sheet for a solar cell includes an acrylic resin and a polyolefin resin in the outermost layer on a side adjacent to a sealing material of a solar cell module.

In a case where a combination of an acrylic resin and a polyolefin resin is used, the content of the acrylic resin is preferably 3 mass% to 50 mass%, more preferably 5 mass% to 40 mass%, and still more preferably 7 mass% to 25

mass% with respect to the total content of the polyolefin resin and the acrylic resin in the fourth polymer layer.

The resin component included in the fourth polymer layer may be crosslinked by the crosslinking agent. It is preferable that a crosslinked structure is formed in the fourth polymer layer because adhesiveness can be further improved. Examples of the crosslinking agent include an epoxy crosslinking agent, an isocyanate crosslinking agent, a melamine crosslinking agent, a carbodiimide crosslinking agent, and an oxazoline crosslinking agent which are the examples described above regarding the first polymer layer. In particular, it is preferable that the crosslinking agent is an oxazoline crosslinking agent in the fourth polymer layer. As the crosslinking agent having an oxazoline group, for example, EPOCROS (registered trade name) K-2010E, K-2020E, K-2030E, WS-500, or WS-700 (all of which are manufactured by Nippon Shokubai Co., Ltd.) can be used.

The addition amount of the crosslinking agent is preferably 0.5 mass% to 50 mass%, more preferably 3 mass% to 40 mass%, and still more preferably 5 mass% to 30 mass% with respect to the mass of the resin component included in the fourth polymer layer. In a case where the addition amount of the crosslinking agent is 0.5 mass% or higher, a sufficient crosslinking effect can be obtained while maintaining the strength and adhesiveness of the fourth polymer layer. In a case where the addition amount of the crosslinking agent is 50 mass% or lower, a long pot life of the coating solution can be maintained. In a case where the addition amount of the crosslinking agent is lower than 40 mass%, the coating surface shape can be improved.

In a case where a crosslinking agent is used in the fourth polymer layer, the crosslinking agent may be used in combination with a crosslinking catalyst. By the addition of the crosslinking catalyst, a crosslinking reaction between the resin component and the crosslinking agent is promoted, and solvent resistance is improved. In addition, the crosslinking reaction progresses satisfactorily, and adhesiveness between the fourth polymer layer and an adjacent layer is further improved.

In particular, in a case where a crosslinking agent having an oxazoline group (oxazoline crosslinking agent) is used as the crosslinking agent, it is preferable that the crosslinking catalyst is used.

Examples of the crosslinking catalyst include an onium compound.

Examples of the onium compound include an ammonium salt, a sulfonium salt, an oxonium salt, an iodonium salt, a phosphonium salt, a nitronium salt, a nitrosonium salt, and a diazonium salt.

As the crosslinking catalyst, the exemplary compounds described above regarding the first polymer layer can be used, and preferable examples are also the same.

As the crosslinking catalyst included in the fourth polymer layer, one kind may be used alone, or two or more kinds may be used in combination.

The addition amount of the crosslinking catalyst is preferably in a range of 0.1 mass% to 15 mass%, more preferably in a range of 0.5 mass% to 12 mass%, still more preferably in a range of 1 mass% to 10 mass%, even still more preferably in a range of 2 mass% to 7 mass% with respect to the total solid content of the crosslinking agent. "The addition amount of the crosslinking catalyst is 0.1 mass% or higher with respect to the total solid content of the crosslinking agent" represents that the crosslinking catalyst is actively included. In this case, due to the addition of the crosslinking catalyst, a crosslinking reaction between the resin component and the crosslinking agent progresses satisfactorily, and higher solvent resistance is obtained. In addition, it is preferable that the content of the crosslinking catalyst is 15 mass% or lower from the viewpoints of improving solubility, filtration properties of a coating solution, and adhesiveness with the fourth polymer layer and an adjacent layer.

In addition to the resin component, various additives may be added to the fourth polymer layer within a range where the effects according to the embodiment of the present invention do not deteriorate.

Examples of the additives include an antistatic agent and a preservative.

Examples of the antistatic agent include a surfactant such as a nonionic surfactant and an organic conductive material.

As the surfactant used as the antistatic agent which can be included in the fourth polymer layer, for example, a nonionic surfactant or an anionic surfactant is preferable. In particular, a nonionic surfactant is preferable, and a nonionic surfactant having an ethylene glycol chain (polyoxyethylene chain; $-(CH_2-CH_2-O)_n-$) and having no carbon-carbon triple bond (alkyne bond) is preferable. Further, a nonionic surfactant having 7 to 30 ethylene glycol chains is more preferable.

Specific examples of the nonionic surfactant include hexaethylene glycol monododecyl ether, 3,6,9,12,15-pentaoxahexadecan-1-ol, polyoxyethylene phenyl ether, polyoxyethylene methyl phenyl ether, polyoxyethylene naphthyl ether, and polyoxyethylene methyl naphthyl ether. However, the nonionic surfactant is not limited to these examples.

In a case where the surfactant is used as the antistatic agent, the content thereof is preferably 2.5 mass% to 40 mass%, more preferably 5.0 mass% to 35 mass%, and still more preferably 10 mass% to 30 mass% with respect to the weight of the solid content.

In a case where the content of the surfactant is in the above-described range, a decrease in partial discharge voltage is prevented, and adhesiveness with a sealing material (for example, an ethylene-vinyl acetate copolymer; EVA) for sealing a solar cell element is maintained to be high.

Examples of the organic conductive material include: an ionic conductive compound including a cationic conductive compound having a cationic substituent such as an ammonium group, an amine base, or a quaternary ammonium group in a molecule, an anionic conductive compound having an anionic substituent such as a phosphate group, or a carbonate group, and an amphoteric conductive compound having both an anionic substituent and a cationic substituent; and a conductive polymer compound derived from a conjugated polyene skeleton such as polyacetylene, polyparaphenylene, polyaniline, polythiophene, polyparaphenylene vinylene, or polypyrrole.

[Undercoat Layer]

In the transparent sheet for a solar cell, an undercoat layer may be provided at least between the substrate film and the first polymer layer or between the substrate film and the third polymer layer.
By providing the undercoat layer, adhesiveness between the substrate film and the first polymer layer and adhesiveness between the substrate film and the third polymer layer are further improved.
The undercoat layer may be formed using the above-described coating method, or may be formed using an in-line coating method described below.

(In-Line Coating Method)

The undercoat layer is formed using a method including: applying the undercoat layer-forming composition to one surface of the substrate film which is stretched in the first direction; and further stretching the substrate film, to which the undercoat layer-forming composition is applied, in the second direction perpendicular to the first direction along the film surface. That is, the undercoat layer is formed using a so-called in-line coating method which is distinguished from an off-line coating method in which coating is separately performed after winding a film halfway.
By forming the undercoat layer using the in-line coating method, adhesiveness between the substrate film and the first polymer layer and adhesiveness between the substrate film and the third polymer layer are excellent, which is advantageous from the viewpoint of productivity.
It is preferable that the thickness of the undercoat layer is 0.01 μm to 1 μm. The thickness of the undercoat layer is preferably 0.01 μm or more, more preferably 0.03 μm or more, and still more preferably 0.05 μm or more. In addition, the thickness of the coating layer is preferably 1 μm or less, more preferably 0.8 μm or less, and still more preferably 0.7 μm or less.

(Undercoat Layer-Forming Composition)

It is preferable that the undercoat layer is formed using a method including: applying the undercoat layer-forming composition, which is a solution in which the following resin component is dissolved in an appropriate solvent or a dispersion in which the resin component is dispersed in a dispersion medium, to the substrate film which is stretched in the first direction; and stretching the substrate film in the second direction perpendicular to the first direction along the film surface. In addition to the resin component and the solvent or the dispersion medium, optionally, other additives may be added to the undercoat layer-forming composition. As the undercoat layer-forming composition, an aqueous dispersion in which the resin component is dispersed in water is preferably used in consideration of the environment.
A method for obtaining the aqueous dispersion is not particularly limited. For example, as described in JP2003-119328A, a method of adding the above-described components, that is, the resin component and water and optionally adding an organic solvent to a preferably sealable container, and heating and stirring the components can be adopted, and this method is most preferable. According to this method, an excellent aqueous dispersion can be formed using the resin component even substantially without adding a non-volatile aqueous auxiliary agent.
The resin solid content concentration in the aqueous dispersion is not particularly limited and, from the viewpoints of easy coating, easy adjustment of the thickness of the undercoat layer, and the like, is preferably 1 mass% to 60 mass%, more preferably 2 mass% to 50 mass%, and still more preferably 5 mass% to 30 mass% with respect to the total mass of the aqueous dispersion.

~Resin Component~

The resin component included in the undercoat layer is not particularly limited. Examples of the resin component included in the undercoat layer include an acrylic resin, a polyester resin, a polyolefin resin, and a silicone resin.
It is more preferable that the undercoat layer includes an acrylic resin and that the content ratio of the acrylic resin in the resin component included in the undercoat layer is 50 mass% or higher.
In a case where the acrylic resin accounts for 50 mass% or higher of the resin component, the elastic modulus of the undercoat layer can be easily adjusted to be 0.7 GPa or higher, and the cohesion failure resistance of the transparent

sheet including this undercoat layer can be further improved.

The acrylic resin is not particularly limited as long as it is a resin having a structural unit derived from acrylic acid or methacrylic acid. From the viewpoint of the elastic modulus of the undercoat layer including the acrylic resin, as the acrylic resin, an acrylic resin including polymethyl methacrylate or polyethyl acrylate is more preferable, and an acrylic resin having a styrene skeleton is more preferable.

As the acrylic resin, a commercially available product may be used. Examples of the commercially available product of the acrylic resin include AS-563A (manufactured by Daicel FineChem Ltd.) and JURYMER (registered trade name) ET-410 and SEK-301 (both of which are manufactured by Nihon Junyaku Co., Ltd.).

In addition, as the acrylic resin, a siloxane-containing acrylic resin can also be used. As the siloxane-containing acrylic resin, a commercially available product may be used. Examples of the commercially available product include CERANATE (registered trade name) WSA1060 and WSA1070 (both of which are manufactured by DIC Corporation) and H7620, H7630, and H7650 (both of which are manufactured by Asahi Kasei Chemicals Corporation).

As the polyester resin, for example, polyethylene terephthalate (PET) or polyethylene-2,6-naphthalate (PEN) is preferable.

As the polyester resin, a commercially available product may be used. As the commercially available product, for example, VYLONAL (registered trade name) MD-1245 (manufactured by Toyobo Co., Ltd.) can be preferably used.

As the polyurethane resin, for example, a carbonate-based urethane resin is preferable. For example, SUPERFLEX (registered trade name) 460 (manufactured by DKS Co., Ltd.) can be preferably used.

As the polyolefin resin, for example, a modified polyolefin copolymer is preferable. As the polyolefin resin, a commercially available product may be used. Examples of the commercially available product include ARROW BASE (registered trade name) SE-1013N, SD-1010, TC-4010, and TD-4010 (all of which are manufactured by Unitika Ltd.), HITECH S3148, S3121, and S8512, (all of which are manufactured by Toho Chemical Industry Co., Ltd.), and CHEMIPEARL (registered trade name) S-120, S-75N, V100, and EV210H (all of which are manufactured by manufactured by Mitsui Chemicals, Inc.). Among these, ARROW BASE (registered trade name) SE-1013N (manufactured by Unitika Ltd.), which is a terpolymer of low-density polyethylene, acrylic acid ester, and maleic anhydride, is preferable from the viewpoint of improving adhesiveness.

In addition, an acid-modified polyolefin described in paragraphs "0022" to "0034" of JP2014-76632A can also be preferably used.

~Other Additives~

The other additives can be selected depending on a function which is imparted to the undercoat layer, and examples thereof include a crosslinking agent for improving the film hardness, a surfactant for improving the uniformity of the coating film, an antioxidant, and a preservative.

It is preferable that the undercoat layer-forming composition includes a crosslinking agent.

By adding the crosslinking agent to the undercoat layer-forming composition, a crosslinked structure is formed in the resin component included in the undercoat layer-forming composition, and a layer having improved adhesiveness and strength can be formed.

In a case where the undercoat layer-forming composition includes a crosslinking agent, it is preferable that the crosslinking agent is used in combination with a crosslinking catalyst.

As the crosslinking agent and the crosslinking catalyst, the examples described above regarding the first polymer layer can also be preferably used in the undercoat layer, and preferable examples are also the same.

The aqueous dispersion may include a surfactant and a non-volatile aqueous auxiliary agent such as an emulsifier. By appropriately selecting the non-volatile aqueous auxiliary agent, productivity and various performances can be simultaneously improved more efficiently.

The non-volatile aqueous auxiliary agent refers to a non-volatile compound contributing to the dispersing of the resin or stabilization. Examples of the non-volatile aqueous auxiliary agent include a cationic surfactant, an anionic surfactant, a nonionic surfactant, an amphoteric surfactant, a fluorine surfactant, a reactive surfactant, and a water-soluble polymer. In general, a compound used for emulsion polymerization and an emulsifier can also be used. In particular, a fluorine surfactant or a nonionic surfactant is preferable.

The fluorine surfactant or the nonionic surfactant described above is nonionic. Therefore, in a case where a polyester film is used as the substrate film, the fluorine surfactant or the nonionic surfactant does not function as a catalyst for decomposition of polyester, and thus weather fastness is excellent. The addition amount of the surfactant is preferably 1 ppm to 100 ppm, more preferably 5 ppm to 70 ppm, and still more preferably 10 ppm to 50 ppm with respect to the aqueous dispersion.

[Other Layers]

(Gas Barrier Layer)

A gas barrier layer may be provided on a surface of the substrate film opposite to the third polymer layer. The gas barrier layer is a layer having a dampproof function that prevents permeation of water or gas into the substrate film.
The water vapor permeability (moisture permeability) of the gas barrier layer is preferably $10^2$ g/$m^2$·day to $10^{-6}$ g/$m^2$·day, more preferably $10^1$ g/$m^2$.day to $10^{-5}$ g/$m^2$·day, still more preferably $10^0$ g/$m^2$·day to $10^{-4}$ g/$m^2$·day.
In order to form the gas barrier layer having a moisture permeability in the above-described range, a dry process is preferable. Examples of a method of forming the gas barrier layer having gas barrier properties through a dry process include: a vacuum deposition method such as resistance heating deposition, electron beam deposition, induced heating deposition, or a plasma or ion beam-assisted method thereof; a sputtering method such as a reactive sputtering method, an ion beam sputtering method, or an electron cyclotron resonance (ECR) sputtering method; a physical vapor deposition method (PVD method) such as an ion plating method; and a chemical vapor deposition method (CVD method) in which heat, light, plasma, or the like is used. Among these, a vacuum deposition method of forming a film using a vapor deposition method in a vacuum is preferable.
A material for forming the gas barrier layer can be appropriately selected from materials having light-transmitting property.
It is preferable that the thickness of the gas barrier layer is 1 μm to 30 μm. In a case where the thickness of the gas barrier layer is 1 μm or more, water is not likely to permeate into the substrate film over time, and hydrolysis resistance is excellent. In a case where the thickness of the gas barrier layer is 30 μm or less, wrinkling is prevented in the substrate film.

[Use of Transparent Sheet for Solar Cell]

The transparent sheet for a solar cell can be suitably used for a back sheet for a solar cell or the like.
The transparent sheet for a solar cell can also be used as a front substrate of a solar cell.

<Transparent Back Sheet for Solar Cell>

A transparent back sheet for a solar cell includes the above-described transparent sheet for a solar cell according to the embodiment of the present invention. The transparent back sheet for a solar cell may further include other layers in addition to the transparent sheet for a solar cell.
In the transparent back sheet for a solar cell, the above-described transparent sheet for a solar cell is used. Therefore, bleed-out resistance and light fastness are excellent.

<Solar Cell Module>

A solar cell module includes the above-described transparent back sheet for a solar cell according to the embodiment of the present invention.
The transparent back sheet for a solar cell according to the embodiment of the present invention included in the solar cell module has excellent light fastness and bleed-out resistance. As a result, in the solar cell module, stable power generation performance can be maintained for a long period of time.
Specifically, the solar cell module includes: an element structure portion that includes a solar cell element and a sealing material for sealing the solar cell element; a transparent substrate (front substrate such as a glass substrate) that is disposed on one surface of the element structure portion and on which sunlight is incident; and the transparent back sheet for a solar cell that is disposed on the other surface of the element structure portion. This solar cell module has a laminate structure of the transparent front substrate/the element structure portion/the back sheet. More specifically, the element structure portion where the solar cell element for converting sunlight energy into electric energy is disposed between the transparent front substrate, which is disposed on the side where sunlight is directly incident, and the transparent back sheet for a solar cell according to the embodiment of the present invention. As a result, in the space between the front substrate and the transparent back sheet for a solar cell, the element structure portion (for example, a solar cell) including the solar cell element is sealed and adhered using a sealing material such as an ethylene-vinyl acetate copolymer (EVA). In particular, the transparent back sheet for a solar cell according to the embodiment of the present invention has excellent adhesiveness with the EVA and can improve long-term durability.
The details of members other than the solar cell module, the solar cell element, and the transparent back sheet can be found in "Constituent Material of Photovoltaic Power Generation System" (edited by Eiichi Sugimoto, Kogyo Chosakai Publishing Co., Ltd., 2008).

The transparent substrate may have light-transmitting property so as to allow transmission of sunlight and can be appropriately selected from light-permeable substrates. From the viewpoint of power generation efficiency, it is preferable that the light transmittance is as high as possible. As the substrate, for example, a transparent resin such as a glass substrate or an acrylic resin can be preferably used.
Examples of the solar cell element which is applicable include various solar cell elements, for example, a silicon element formed of monocrystalline silicon, polycrystalline silicon, or amorphous silicon, or a III-V group or II-VI group compound semiconductor element such as copper-indium-gallium-selenium, copper-indium-selenium, cadmium-tellurium, or gallium-arsenic. The space between the substrate and the transparent back sheet for a solar cell can be sealed with a resin (a so-called sealing material) such as an ethylene-vinyl acetate copolymer.
As the solar cell element, a solar cell element having light-transmitting property may be used.

[Examples]

Hereinafter, the embodiment of the present invention will be described in more detail using examples. However, the embodiment of the present invention is not limited to the following examples as long as it does not depart from the scope of the present invention. Unless specified otherwise, "part(s)" represents "part(s) by mass".

(Example 1)

-Synthesis of Polyester-

A slurry including 100 kg of high-purity terephthalic acid (manufactured by Mitsui Chemicals, Inc.) and 45 kg of ethylene glycol (manufactured by Nippon Shokubai Co., Ltd.) was sequentially supplied for 4 hours to an esterification reaction chamber to which about 123 kg of bis(hydroxyethyl) terephthalate and which was held under conditions of temperature: 250°C and pressure: $1.2 \times 10^5$ Pa. After completion of the supply, an esterification reaction was performed for 1 hour. Next, 123 kg of the obtained esterification reaction product was transported to a polycondensation reaction chamber.
Next, 0.3 mass% of ethylene glycol with respect to the obtained polymer was added to the polycondensation reaction chamber to which the esterification reaction product was transported. After stirring for 5 minutes, an ethylene glycol solution of cobalt acetate and an ethylene glycol solution of manganese acetate were added such that the amounts thereof were 30 ppm and 15 ppm with respect to the obtained polymer, respectively. Further, after stirring for 5 minutes, a 2 mass% ethylene glycol solution of a titanium alkoxide compound was added such that the amount thereof was 5 ppm with respect to the obtained polymer. After 5 minutes, a 10 mass% ethylene glycol solution of ethyl diethylphosphonoacetate was added such that the amount thereof was 5 ppm with respect to the obtained polymer. Next, while stirring the oligomer at 30 rpm, the temperature of the reaction system was slowly increased from 250°C to 285°C, and the pressure thereof was reduced to 40 Pa. The time required for the reaction system to reach the final temperature and the final pressure was 60 minutes. Once the stirring torque reached a predetermined value, the reaction system was purged with nitrogen and was returned to normal pressure, and the polycondensation reaction was stopped. The polymer obtained by the polycondensation reaction was jetted into cold water in a strand shape and was immediately cut to prepare a polymer pellet (diameter: about 3 mm, length: about 7 mm). The time required for the stirring torque to reach the predetermined value from the start of the pressure reduction was 3 hours.
As the titanium alkoxide compound, a titanium alkoxide compound (Ti content=4.44 mass%) which was synthesized in Example 1 described in paragraph "0083" of JP2005-340616A was used.

-Solid Phase Polymerization-

The pellet obtained as described above was held at a temperature of 220°C for 30 hours in a vacuum chamber held at 40 Pa, and solid phase polymerization was performed.

-Preparation of Polyester Film-

The pellet having undergone the solid phase polymerization as described above was melted at 280°C and was cast on a metal drum to prepare a non-stretched polyethylene terephthalate (PET) film having a thickness of about 3 mm.
Next, the non-stretched PET film was stretched to 3.4 times in the machine direction (MD) at 90°C. Next, before the MD stretching and after a transverse direction (TD) stretching, an undercoat layer-forming composition having the following composition was applied to one surface of the uniaxially stretched PET film using an in-line coating method such that the application amount thereof was 5.1 ml/$m^2$.
The PET film to which the undercoat layer-forming composition was applied was stretched in the TD direction.

As a result, an undercoat layer having a thickness of 0.1 μm and an elastic modulus of 1.5 GPa was formed. The TD stretching was performed under conditions of temperature: 105°C and stretching ratio: 4.5 times.

Regarding the PET film on which the undercoat layer was formed, a heat fixing treatment was performed at a film surface temperature of 190°C for 15 seconds, and a heat relaxation treatment was performed in the MD direction and the TD direction under conditions of 190°C, MD relaxation ratio: 5%, and TD relaxation ratio: 11%. As a result, a biaxially stretched PET film having a thickness of 250 μm on which the undercoat layer was formed was obtained.

(Composition of Undercoat Layer-Forming Composition)

- Acrylic resin aqueous dispersion: 21.9 parts
  [AS-563A, manufactured by Daicel FineChem Ltd., a latex having a styrene skeleton having a solid content of 28 mass%]
- Water-soluble oxazoline crosslinking agent: 4.9 parts
  [EPOCROS (registered trade name) WS-700, manufactured by Nippon Shokubai Co., Ltd., solid content: 25 mass%]
- Fluorine surfactant: 0.1 parts
- Distilled water: 73.1 parts

Using a method described below, a third polymer layer and a fourth polymer layer were formed on the polyester film obtained as described above.

First, a third polymer layer-forming composition (3-A) was prepared to have the following composition.

-Third Polymer Layer-Forming Composition (3-A)-

- Aqueous dispersion of polymer having an ultraviolet absorbing partial structure: 7.1 parts
  [ultraviolet absorbing acrylic resin, TINUVIN (registered trade name) 479-DW, manufactured by BASF SE, solid content: 40 mass%]
- Aqueous dispersion of binder polymer: 29.5 parts
  [acrylic resin, AS-563A, manufactured by Daicel FineChem Ltd., a latex having a styrene skeleton having a solid content of 28 mass%]
- Water-soluble oxazoline crosslinking agent: 8.3 parts
  [EPOCROS (registered trade name) WS-700, manufactured by Nippon Shokubai Co., Ltd., solid content: 25 mass%]
- Crosslinking catalyst: 0.6 parts
  [ammonium secondary phosphate aqueous solution, solid content: 35 mass%]
- Water: balance with respect to the total amount of 100 parts

The obtained third polymer layer-forming composition was applied to a surface of the substrate film (polyester film) where the undercoat layer was formed such that the thickness after drying (dry film thickness) was 2.4 μm, and then was dried at 170°C for 2 minutes. As a result, a third polymer layer was formed.

Next, a fourth polymer layer-forming composition having the following composition was applied to a surface of the third polymer layer such that the dry film thickness was 0.5 μm, and then was dried. As a result, a fourth polymer layer was formed.

-Fourth Polymer Layer-Forming Composition (4-A)-

- Polyolefin resin aqueous dispersion: 16.4 parts
  [ARROW BASE (registered trade name) SE-1013N, manufactured by Unitika Ltd., solid content: 20 mass%]
- Water-soluble oxazoline crosslinking agent: 1.7 parts
  [EPOCROS (registered trade name) WS-700, manufactured by Nippon Shokubai Co., Ltd., solid content: 25 mass%]
- Nonionic surfactant: 9.3 parts
  [EMALEX (registered trade name) 110, manufactured by Nihon Emulsion Co., Ltd., solid content: 10 mass%]
- Water: balance with respect to the total amount of 100 parts

Further, using a first polymer layer-forming composition having the following composition and a second polymer layer-forming composition having the following composition, a first polymer layer and a second polymer layer were sequentially formed on a surface of the substrate film where the undercoat layer was not formed. As a result, a transparent back sheet for a solar cell was obtained.

-First Polymer Layer-Forming Composition (1-A)-

- Aqueous dispersion of polymer having an ultraviolet absorbing partial structure: 7.2 parts
  [ultraviolet absorbing acrylic resin, TINUVIN (registered trade name) 479-DW, manufactured by BASF SE, solid content: 40 mass%]
- Aqueous dispersion of binder polymer: 45.8 parts
  [siloxane-containing acrylic resin, CERANATE (registered trade name) WSA1070, manufactured by DIC Corporation, solid content: 38 mass%]
- Water-soluble oxazoline crosslinking agent: 14.1 parts
  [EPOCROS (registered trade name) WS-700, manufactured by Nippon Shokubai Co., Ltd., solid content: 25 mass%]
- Crosslinking catalyst: 1.5 parts
  [ammonium secondary phosphate aqueous solution, solid content: 35 mass%]
- Fluorine surfactant: 1.1 parts
  [solid content: 2 mass%]
- Water: balance with respect to the total amount of 100 parts

Formation of First Polymer Layer

The obtained first polymer layer-forming composition was applied to a back surface of the substrate film (surface where the third polymer layer was not formed) such that the application amount of the solid content was 4.7 g/m$^2$, and then was dried at 170°C for 2 minutes. As a result, a first polymer layer having a thickness of 7.0 μm was formed.
A coating solution of a second polymer layer-forming composition (2-A) having the following composition was applied to a surface of the first polymer layer such that the application amount of the solid content was 1.3 g/m$^2$, and then was dried at 170 for 2 minutes. As a result, a second polymer layer having a thickness of 0.8 μm was formed.

-Second Polymer Layer-Forming Composition (2-A)-

- Fluororesin: 20.7 parts
  [OBBLIGATO (registered trade name) SW0011F, manufactured by AGC Coat-Tech Co., Ltd., solid content: 36 mass%]
- Water-soluble oxazoline crosslinking agent: 6.0 parts
  [EPOCROS (registered trade name) WS-700, manufactured by Nippon Shokubai Co., Ltd., solid content: 25 mass%]
- Crosslinking catalyst: 0.6 parts
  [ammonium secondary phosphate aqueous solution, solid content: 35 mass%]
- Colloidal silica: 2.4 parts
  [SNOWTEX (registered trade name) UP, manufactured by Nissan Chemical Industries Ltd., solid content: 2 mass%]
- Silane coupling agent: 2.4 parts
  [TSL8340, manufactured by Momentive Performance Materials Inc., solid content: 2 mass%]
- Lubricant: 12.4 parts
  [polyethylene wax, CHEMIPEARL (registered trade name) W900, manufactured by Mitsui Chemicals, Inc., solid content: 5 mass%]
- Nonionic surfactant: 0.7 parts
  [polyoxyalkylene alkyl ether, NAROACTY (registered trade name) CL-95, manufactured by Sanyo Chemical Industries Ltd., solid content: 5 mass%]
- Water: balance with respect to the total amount of 100 parts

(Examples 2 to 7 and Comparative Examples 1 to 4)

Transparent sheets for a solar cell according to Examples 2 to 7 and Comparative Examples 1 to 4 were

prepared using the same method as in Example 1, except that the first polymer layer-forming composition and the thickness thereof after drying were changed as shown in Table 1.

As the first polymer layer-forming composition, 1-F was used in Example 2, 1-G was used in Example 3, 1-H was used in Example 4, 1-I was used in Example 5, 1-J was used in Example 6, 1-K was used in Example 7, 1-B was used in Comparative Example 1, 1-C was used in Comparative Example 2, 1-D was used in Comparative Example 3, and 1-E was used in Comparative Example 4.

[Table 1]

| Composition, No. | Polymer A Having Ultraviolet absorbing partial structure | | Ultraviolet Absorber | | Binder Polymer B | | | | Crosslinking Agent | | Crosslinking Catalyst | Surfactant | Solvent | | Total Amount [part(s) by mass] | Solid Content [mass %] | Solid Content Ratio Polymer A Having Ultraviolet absorbing partial structure: Binder Polymer B | Thickness after Drying [μm] |
|---|---|---|---|---|---|---|---|---|---|---|---|---|---|---|---|---|---|---|
| | Ultraviolet Absorbing Acrylic Resin | Ultraviolet Absorbing Acrylic Resin | - | - | Siloxane-Containing Acrylic Resin | Siloxane-Containing Acrylic Resin | Acrylic Resin | Polyolefin Resin | | | | | | | | | | |
| | TINUVIN 479DW | NEWCOAT UVA-204W | TINUVIN 479 | BT-120 | CERANATE WSA1070 | SYMAC GS-30 | AS-563A | ARROWBASE SE-1013N | EPOCROS WS-700 | EPOCROS RPS-1005 | Ammonium Secondary Phosphate | Fluorine Surfactant | Surfactant Water Toluene | | | | | |
| 1-A | 72 | | | | 45-8 | | | | 14.1 | | 1.5 | 1.1 | 30.0 | | 100 | 24 | 14:86 | 7.0 |
| 1-B | | | 2.9 | | | 87.0 | | | | 3.5 | | 1.1 | | 6.6 | 100 | 24 | 14:86 | 7.0 |
| 1-C | | | | 2.0 | 45.8 | | | | 14.1 | | 1.5 | 1.1 | 35.5 | | 100 | 23 | 10:90 | 7.0 |
| 1-D | 7.2 | | | | | | | 87.1 | | | 1.5 | 1.1 | | | 100 | 20 | 14:86 | 5.8 |
| 1-E | | | | | 45.8 | | | | 14-1 | | 1.5 | 1.1 | 37.2 | | 100 | 21 | - | 5.5 |
| 1-F | | 29.0 | | | 30.8 | | | | 14.1 | | 1.5 | 1.2 | 23.4 | | 100 | 22 | 33:67 | 6.5 |
| 1-G | 7.2 | | | | | | 62.2 | | 14.1 | | 1.5 | 1.1 | 13.9 | | 100 | 24 | 14:86 | 7.0 |
| 1-H | 3.6 | | | | 45.8 | | | | 14.1 | | 1.5 | 1.2 | 33.8 | | 100 | 23 | 7:93 | 6.5 |
| 1-I | 1.8 | | | | 45.8 | | | | 14.1 | | 1.5 | 1.2 | 35.6 | | 100 | 22 | 3:97 | 6.2 |
| 1-J | 25.4 | | | | 45.8 | | | | 14.1 | | 1.5 | 1.1 | 12.1 | | 100 | 32 | 37:63 | 9.5 |
| 1-K | 37.0 | | | | 45.8 | | | | 14.1 | | 1.5 | 1.0 | 0.6 | | 100 | 37 | 45:55 | 11.1 |

The description in Table 1 will be described.

- TINUVIN (registered trade name) 479-DW: an aqueous dispersion of a polymer (ultraviolet absorbing acrylic resin) which has a partial structure having a triazine skeleton, manufactured by BASF SE, solid content: 40 mass%
- NEWCOAT (registered trade name) UVA-204W: an aqueous dispersion of a polymer (ultraviolet absorbing acrylic resin) which has a partial structure having a benzotriazole skeleton, manufactured by Shin-Nakamura Chemical Co., Ltd., solid content: 20 mass%
- TINUVIN (registered trade name) 479: an ultraviolet absorber derived from a triazine skeleton, manufactured by BASF SE
- BT-120: benzotriazole, manufactured by Johoku-Chemical Co., Ltd.
  CERANATE (registered trade name) WSA1070: a siloxane-containing acrylic resin, manufactured by DIC Corporation, solid content: 38 mass%
- SYMAC (registered trade name) GS-30: a siloxane-containing acrylic resin, manufactured by Toagosei Co., Ltd., solid content: 20 mass%
- AS-563A: an acrylic resin, manufactured by Daicel FineChem Ltd., solid content: 28 mass%
- ARROW BASE (registered trade name) SE-1013N: a polyolefin resin, manufactured by Unitika Ltd., solid content: 20 mass%
- EPOCROS (registered trade name) WS-700: a water-soluble oxazoline crosslinking agent, manufactured by Nippon Shokubai Co., Ltd., solid content: 25 mass%
- EPOCROS (registered trade name) RPS-1005: an oxazoline crosslinking agent, manufactured by Nippon Shokubai Co., Ltd., solid content: 100 mass%

(Example 8)

A transparent sheet for a solar cell according to Example 8 was prepared using the same preparation method of the transparent sheet for a solar cell according to Example 1, except that the second polymer layer was not formed.

(Example 9)

A transparent sheet for a solar cell according to Example 9 was prepared using the same preparation method as in Example 1, except that the second polymer layer-forming composition (2-A) was changed to the following second polymer layer-forming composition (2-B).

-Second Polymer Layer-Forming Composition (2-B)-

- Fluororesin: 20.7 parts
  [OBBLIGATO (registered trade name) SW0011F, manufactured by AGC Coat-Tech Co., Ltd., solid content: 36 mass%]
- Water-soluble oxazoline crosslinking agent: 6.0 parts
  [EPOCROS (registered trade name) WS-700, manufactured by Nippon Shokubai Co., Ltd., solid content: 25 mass%]
- Crosslinking catalyst: 0.6 parts
  [ammonium secondary phosphate aqueous solution, solid content: 35 mass%]
- Lubricant: 12.4 parts
  [polyethylene wax, CHEMIPEARL (registered trade name) W900, manufactured by Mitsui Chemicals, Inc., solid content: 5 mass%]
- Nonionic surfactant: 0.7 parts
  [polyoxyalkylene alkyl ether, NAROACTY (registered trade name) CL-95, manufactured by Sanyo Chemical Industries Ltd., solid content: 5 mass%]
- Water: balance with respect to the total amount of 100 parts

(Example 10)

A transparent sheet for a solar cell according to Example 10 was prepared using the same preparation method as in Example 1, except that: the third polymer layer-forming composition (3-A) was changed to the following third polymer layer-forming composition (3-B); and the third polymer layer-forming composition (3-B) was applied such that the thickness after drying was 1.9 μm.

-Third Polymer Layer-Forming Composition (3-B)-

- Aqueous dispersion of binder polymer: 29.5 parts
  [acrylic resin, AS-563A, manufactured by Daicel FineChem Ltd., a latex having a styrene skeleton having a solid content of 28 mass%]
- Water-soluble oxazoline crosslinking agent: 8.3 parts
  [EPOCROS (registered trade name) WS-700, manufactured by Nippon Shokubai Co., Ltd., solid content: 25 mass%]
- Crosslinking catalyst: 0.6 parts
  [ammonium secondary phosphate aqueous solution, solid content: 35 mass%]
- Water: balance with respect to the total amount of 100 parts

(Example 11)

A transparent sheet for a solar cell according to Example 11 was prepared using the same preparation method of the transparent sheet for a solar cell according to Example 1, except that the fourth polymer layer was not formed.

(Example 12)

A transparent sheet for a solar cell according to Example 12 was prepared using the same preparation method as in Example 1, except that: the first polymer layer-forming composition (1-A) was changed to (1-H) shown in Table 1; and the second polymer layer-forming composition (2-A) was changed to the following second polymer layer-forming composition (2-C).

-Second Polymer Layer-Forming Composition (2-C)-

- Aqueous dispersion of polymer having an ultraviolet absorbing partial structure: 3.6 parts
  [ultraviolet absorbing acrylic resin, TINUVIN (registered trade name) 479-DW, manufactured by BASF SE, solid content: 40 mass%]
- Fluororesin: 20.7 parts
  [OBBLIGATO (registered trade name) SW0011F, manufactured by AGC Coat-Tech Co., Ltd., solid content: 36 mass%]
- Water-soluble oxazoline crosslinking agent: 6.0 parts
  [EPOCROS (registered trade name) WS-700, manufactured by Nippon Shokubai Co., Ltd., solid content: 25 mass%]
- Crosslinking catalyst: 0.6 parts
  [ammonium secondary phosphate aqueous solution, solid content: 35 mass%]
- Lubricant: 12.4 parts
  [polyethylene wax, CHEMIPEARL (registered trade name) W900, manufactured by Mitsui Chemicals, Inc., solid content: 5 mass%]
- Nonionic surfactant: 0.7 parts
  [polyoxyalkylene alkyl ether, NAROACTY (registered trade name) CL-95, manufactured by Sanyo Chemical Industries Ltd., solid content: 5 mass%]
- Water: balance with respect to the total amount of 100 parts

The Examples and the Comparative Examples were evaluated as described below, and the evaluation results are shown in Table 2.

-Light Fastness-

A reinforced glass (transparent substrate) having a thickness of 3.2 mm, an EVA sheet (sealing material; SC50B, manufactured by Mitsui Chemicals Inc.), a crystalline solar cell (solar cell element), an EVA sheet (SC50B, manufactured by Mitsui Chemicals Inc.), and one of the transparent sheets for a solar cell obtained as described above in the Examples and the Comparative Examples were laminated in this order, and were hot-pressed using a vacuum laminator (manufactured by Nisshinbo Mechatronics Inc.). As a result, the respective members and the EVA sheet were adhered to each other. Through the above-described steps, a solar cell module was prepared.

The chromaticity (La*b*) of the prepared solar cell module was measured using (CM-700d, manufactured by Konica Minolta Inc.).

Using an ultra-energy irradiation tester (manufactured by Suga Test Instruments Co., Ltd.), the reinforced glass side or the transparent sheet side for a solar cell was irradiated with 100 mW/cm$^2$ of ultraviolet light for 100 hours or 200 hours.

Next, after the ultraviolet irradiation, the chromaticity (La*b*) of the solar cell module was measured, and a color difference Δb* of the solar cell module before and after the ultraviolet irradiation was obtained. Based on the following evaluation standards, the light fastness of the transparent sheet for a solar cell according to each of the Examples and the Comparative Examples was evaluated. As the value of Δb* increases, discoloration caused by ultraviolet light becomes severe, and the light fastness of the transparent sheet becomes low.

(Evaluation Standards)

5: Δb* was 2 or lower
4: Δb* was higher than 2 and 5 or lower
3: Δb* was higher than 5 and 10 or lower
2: Δb* was higher than 10 and 20 or lower
1: Δb* was lower than 20

-Scratch Resistance-

The humidity of the transparent sheet for a solar cell obtained as described above in each of the Examples and the Comparative Examples was controlled in an atmosphere of 25°C and 60% RH for 24 hours. Next, the surface of the transparent sheet where the second polymer layer was provided was scratched using a sapphire stylus having a 0.1 mmϕ tip at a rate of 1 cm/sec. At this time, the load was continuously changed from 0 g to 100 g. The scratched second polymer layer surface of the transparent sheet was observed with an optical microscope, and a minimum load at which a scratch was observed was obtained. Based on the following evaluation standards, the scratch resistance of the transparent sheet for a solar cell according to each of the Examples and the Comparative Examples was evaluated. A high minimum load at which a scratch was observed represents excellent scratch resistance.

(Evaluation Standards)

5: the minimum load at which a scratch was observed on the surface of the second polymer layer was 30 g or higher
4: the minimum load at which a scratch was observed on the surface of the second polymer layer was 25 g or higher and lower than 30 g
3: the minimum load at which a scratch was observed on the surface of the second polymer layer was 20 g or higher and lower than 25 g
2: the minimum load at which a scratch was observed on the surface of the second polymer layer was 15 g or higher and lower than 20 g
1: the minimum load at which a scratch was observed on the surface of the second polymer layer was lower than 15 g

-Bleed-Out Resistance (Haze Change)-

The haze value of the transparent sheet for a solar cell obtained as described above in each of the Examples and the Comparative Example was measured using a haze meter (HZ-1, manufactured by Suga Test Instruments Co., Ltd.) to obtain an initial haze value.

Each of the transparent sheets was left to stand in a dry (10% RH or lower) atmosphere of 120°C for 50 hours.

After being left to stand in the dry atmosphere for 50 hours, the haze value of each of the transparent sheets was measured to obtain a haze value after the test.

The haze value after the test was subtracted from the initial haze value to obtain a Δhaze value. Based on the following evaluation standards, the bleed-out resistance of the transparent sheet for a solar cell according to each of the Examples and the Comparative Examples was evaluated. A high Δhaze value represents low bleed-out resistance of the transparent sheet.

(Evaluation Standards)

5: the Δhaze value was 15% or lower
4: the Δhaze value was higher than 15% and 20% or lower
3: the Δhaze value was higher than 20% and 25% or lower
2: the Δhaze value was higher than 25% and 30% or lower
1: the Δhaze value was higher than 30%

-EVAAdhesiveness-

The transparent sheet for a solar cell obtained as described above in each of the Examples and the Comparative Examples was cut to prepare two sample pieces having a size of 20 mm width×150 mm. These two sample pieces were disposed such that the fourth polymer layer side (in the transparent sheet where the fourth polymer layer was not provided, the third polymer layer side) was positioned on the inside. An ethylene-vinyl acetate copolymer (EVA) sheet (SC50B, manufactured by Mitsui Chemicals Inc.) which was cut in a size of 20 mm width×100 mm length was interposed between the sample pieces to obtain a laminate. This laminate was hot-pressed using a vacuum laminator (manufactured by Nisshinbo Mechatronics Inc.). As a result, the respective transparent sheets and the EVA were adhered to each other. At this time, adhesion conditions are as follows.
Using a vacuum laminator, the inside of the chamber was evacuated at 128°C for 3 minutes, and the laminate was pressed for 2 minutes for temporary adhesion. Next, a main adhesion treatment was performed using a dry oven at 150°C for 30 minutes. This way, a sample for adhesion evaluation was obtained, in which a portion having a length of 20 mm from one end of the two adhered sample pieces was not adhered to the EVA sheet, and the remaining portion having a length of 100 mm was adhered to the EVA sheet.
The EVA non-adhered portion of the obtained sample for adhesion evaluation was interposed between upper and lower clips of TENSILON (RTC-1210A, manufactured by Orientec Co., Ltd.), and a tensile test was performed at a peeling angle of 180° and a pulling rate of 300 mm/min to measure an adhesion force.
Based on the measured adhesion force and the following evaluation standards, the EVA adhesiveness of the transparent sheet for a solar cell according to each of the Examples and the Comparative Examples was evaluated.

<Evaluation Criteria>

3: the adhesion force was 40 N/10 mm or higher, and the adhesiveness was significantly high
2: the adhesion force was 15 N/10 mm or higher and lower than 40 N/10 mm, and the adhesiveness was high
1: the adhesion force was lower than 15 N/10 mm or higher, and adhesion failure was significant

[Table 2]

| | First Polymer Layer (Ultraviolet Absorbing Layer) | Second Polymer Layer (Scratch-Resistant Layer) | Third Polymer Layer (Ultraviolet Absorbing Layer) | Fourth Polymer Layer (EVA Easily Adhesive Layer) | Total Light Transmittance | Ultraviolet Irradiation from Transparent Sheet Side for Solar Cell | | | Bleed-Out Resistance ΔHaze 120°C/dry/50 h | Ultraviolet Irradiation from Reinforced Glass Side | | |
|---|---|---|---|---|---|---|---|---|---|---|---|---|
| | | | | | | Light Fastness Δb* 100 mW/cm$^2$ | | Scratch Resistance Continuous Load Scratch 0-100 g | | Light Fastness Δb* 100 mW/cm$^2$ | | EVA Adhesiveness 180° Peeling [N/10 mm] |
| | | | | | | 100h | 200h | | | 100h | 200h | |
| Example 1 | 1-A | 2-A | 3-A | 4-A | 3 | 5 | 5 | 5 | 5 | 5 | 5 | 3 |
| Example 2 | 1-F | 2-A | 3-A | 4-A | 3 | 5 | 3 | 5 | 5 | 5 | 5 | 3 |
| Example 3 | 1-G | 2-A | 3-A | 4-A | 3 | 5 | 5 | 3 | 5 | 5 | 5 | 3 |
| Example 4 | 1-H | 2-A | 3-A | 4-A | 3 | 5 | 4 | 5 | 5 | 5 | 5 | 3 |
| Example 5 | 1-1 | 2-A | 3-A | 4-A | 3 | 5 | 3 | 5 | 5 | 5 | 5 | 3 |
| Example 6 | 1-J | 2-A | 3-A | 4-A | 3 | 5 | 5 | 5 | 4 | 5 | 5 | 3 |
| Example 7 | 1-K | 2-A | 3-A | 4-A | 3 | 5 | 5 | 5 | 3 | 5 | 5 | 3 |
| Example 8 | 1-A | None | 3-A | 4-A | 3 | 5 | 5 | 2 | 4 | 5 | 5 | 3 |
| Example 9 | 1-A | 2-B | 3-A | 4-A | 3 | 5 | 5 | 3 | 5 | 5 | 5 | 3 |
| Example 10 | 1-A | 2-A | 3-B | 4-A | 3 | 5 | 5 | 5 | 5 | 4 | 4 | 3 |
| Example 11 | 1-A | 2-A | 3-A | None | 3 | 5 | 5 | 5 | 4 | 5 | 5 | 2 |
| Example 12 | 1-H | 2-C | 3-A | 4-A | 3 | 5 | 5 | 5 | 3 | 5 | 5 | 3 |
| Comparative Example 1 | 1-B | 2-A | 3-A | 4-A | 3 | 5 | 5 | 5 | 1 | 5 | 5 | 3 |
| Comparative Example 2 | 1-C | 2-A | 3-A | 4-A | 3 | 5 | 3 | 5 | 1 | 5 | 5 | 3 |
| Comparative Example 3 | 1-D | 2-A | 3-A | 4-A | 3 | 5 | 5 | 5 | 1 | 5 | 5 | 3 |
| Comparative Example 4 | 1-E | 2-A | 3-A | 4-A | 3 | 1 | 1 | 5 | 5 | 5 | 5 | 3 |

It can be seen from Table 2 that, in all the transparent sheets for a solar cell according to the Examples, bleed-out resistance and light fastness were excellent.

In addition, it can be seen from a comparison between Example 1 and Example 2 that, in the transparent sheet for a solar cell according to Example 1 including the polymer A having an ultraviolet absorbing partial structure in which a triazine skeleton was included as a skeleton having an ultraviolet absorbing performance, light fastness was excellent.

In addition, it can be seen from a comparison between Example 1 and Examples 4 to 7 that: in a case where the content of the polymer A having an ultraviolet absorbing partial structure is 0.05 to 0.60 with respect to the content of the binder polymer B, light fastness and bleed-out resistance can be realized at a higher level; and in a case where the content of the polymer A having an ultraviolet absorbing partial structure is 0.10 to 0.40 with respect to the content of the binder polymer B, light fastness and bleed-out resistance can be realized at a much higher level.

The disclosure of Japanese Patent Application No. 2015-074022 filed on March 31, 2015 is incorporated herein in its entirety.

All publications, patent applications, and technical standards mentioned in this specification are herein incorporated by reference to the same extent as if each individual publication, patent application, or technical standard was specifically and individually indicated to be incorporated by reference.

## Claims

**1.** A transparent sheet for a solar cell comprising:

a substrate film; and
a first polymer layer that is disposed on one surface of the substrate film and includes a polymer A having an ultraviolet absorbing partial structure and a binder polymer B, in which the polymer A having an ultraviolet absorbing partial structure and the binder polymer B have the same kind of structural units.

**2.** The transparent sheet for a solar cell according to claim 1,
wherein the ultraviolet absorbing partial structure of the polymer A having an ultraviolet absorbing partial structure has at least one skeleton selected from the group consisting of a triazine skeleton and a benzotriazole skeleton.

**3.** The transparent sheet for a solar cell according to claim 1 or 2,
wherein the ultraviolet absorbing partial structure of the polymer A having an ultraviolet absorbing partial structure has a triazine skeleton.

**4.** The transparent sheet for a solar cell according to any one of claims 1 to 3,
wherein a ratio of a content of the polymer A having an ultraviolet absorbing partial structure to a content of the binder polymer B is 0.05 to 0.60 by mass.

**5.** The transparent sheet for a solar cell according to any one of claims 1 to 4,
wherein a thickness of the first polymer layer is 1 $\mu$m to 15 $\mu$m.

**6.** The transparent sheet for a solar cell according to any one of claims 1 to 5, further comprising:

a second polymer layer that is provided on the first polymer layer and includes a filler.

**7.** The transparent sheet for a solar cell according to any one of claims 1 to 6,
wherein a ratio of a content of the polymer A having an ultraviolet absorbing partial structure to a content of the binder polymer B is 0.10 to 0.40 by mass.

**8.** The transparent sheet for a solar cell according to any one of claims 1 to 7, further comprising:

a third polymer layer that is provided on a surface of the substrate film opposite to the surface, where the first polymer layer is disposed, and includes the polymer A having an ultraviolet absorbing partial structure and a binder polymer C.

**9.** The transparent sheet for a solar cell according to any one of claims 1 to 8,
wherein at least one polymer layer including the polymer A having an ultraviolet absorbing partial structure includes an ultraviolet absorbing acrylic resin as the polymer A having an ultraviolet absorbing partial structure and includes

an acrylic resin as the binder polymer B.

**10.** The transparent sheet for a solar cell according to any one of claims 1 to 9, wherein the binder polymer B is a siloxane-containing acrylic resin.

**11.** The transparent sheet for a solar cell according to any one of claims 1 to 10, wherein the first polymer layer further includes an oxazoline crosslinking agent.

**12.** The transparent sheet for a solar cell according to claim 11, wherein the first polymer layer further includes a crosslinking catalyst.

**13.** The transparent sheet for a solar cell according to any one of claims 1 to 12, wherein the substrate film is a polyester film.

**14.** A transparent back sheet for a solar cell comprising:

the transparent sheet for a solar cell according to any one of claims 1 to 13.

**15.** A solar cell module comprising:

an element structure portion that includes a solar cell element and a sealing material for sealing the solar cell element;
a transparent substrate that is disposed on one surface of the element structure portion and on which sunlight is incident; and
the transparent back sheet for a solar cell according to claim 14 that is disposed on the other surface of the element structure portion.

## INTERNATIONAL SEARCH REPORT

International application No.
PCT/JP2015/082160

A. CLASSIFICATION OF SUBJECT MATTER
*H01L31/049*(2014.01)i, *B32B27/18*(2006.01)i

According to International Patent Classification (IPC) or to both national classification and IPC

B. FIELDS SEARCHED

Minimum documentation searched (classification system followed by classification symbols)
H01L31/02-31/078, 31/18-31/20, 51/42-51/48, H02S10/00-50/15, B32B27/18

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2012-116112 A (Fujifilm Corp.), 21 June 2012 (21.06.2012), paragraphs [0010], [0042], [0048], [0085], [0100] & WO 2012/073803 A1 | 1-15 |
| Y | JP 2013-87240 A (Dainichiseika Color & Chemicals Mfg. Co., Ltd.), 13 May 2013 (13.05.2013), claims 1, 13; paragraphs [0002] to [0007], [0033], [0079] to [0085], [0113] (Family: none) | 1-15 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 27 November 2015 (27.11.15) | 12 January 2016 (12.01.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (July 2009)

**INTERNATIONAL SEARCH REPORT**

International application No.
PCT/JP2015/082160

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2013-218261 A (Dainippon Printing Co., Ltd.), 24 October 2013 (24.10.2013), paragraphs [0030] to [0032] (Family: none) | 6 |
| Y | JP 2000-294822 A (Dainippon Printing Co., Ltd.), 20 October 2000 (20.10.2000), claim 1 (Family: none) | 8 |
| Y | JP 2009-259867 A (Nippon Shokubai Co., Ltd.), 05 November 2009 (05.11.2009), paragraphs [0125] to [0126], [0236], [0240] (Family: none) | 9 |
| Y | JP 2014-83834 A (Fujifilm Corp.), 12 May 2014 (12.05.2014), paragraph [0096] (Family: none) | 11-12 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2012069769 A
- JP 2012121999 A
- JP 2012256674 A
- JP 2014076632 A
- JP 2009052011 A
- JP 2003231722 A
- JP 2002020409 A
- JP 9194538 A
- JP H9194538 A
- JP 2003119328 A
- JP 2005340616 A
- JP 2015074022 A


### Non-patent literature cited in the description


- Constituent Material of Photovoltaic Power Generation System. Kogyo Chosakai Publishing Co., Ltd, 2008